# EUROPEAN PATENT SPECIFICATION

(11) **EP 2 770 030 B1**
(45) Date of publication and mention of the grant of the patent: **20.07.2016**
(21) Application number: 14155725.6
(22) Date of filing: 19.02.2014
(51) Int. Cl.: C09D 11/101, C09D 11/38, C09D 11/06

(54) **Inkjet ink composition, inkjet recording method, and printed material**
Tintenstrahlzusammensetzung, Tintenstrahlaufzeichnungsverfahren und gedrucktes Material
Composition d'encre pour jet d'encre, procédé d'enregistrement à jet d'encre et matériau imprimé

(30) Priority: 22.02.2013 JP 2013033774
(43) Date of publication of application: 27.08.2014
(73) Proprietor: FUJIFILM Corporation, Minato-ku Tokyo 106-8620 (JP)
(72) Inventor: Nakano, Ryoichi, Kanagawa 258-8577 (JP); Shimono, Katsuhiro, Kanagawa 258-8577 (JP)
(74) Representative: Hoffmann Eitle

(56) References cited:
- EP-A1- 1 616 920
- EP-A1- 2 444 429
- EP-A2- 1 772 498
- WO-A1-2010/133381
- JP-A- 2002 308 935
- JP-A- 2010 007 000

## Description

### BACKGROUND OF THE INVENTION

### 1. Field of the Invention

The present invention relates to an inkjet ink composition, an inkjet recording method, and a printed material.

### 2. Description of the Related Art

As an image recording method for forming an image on a recording medium such as paper based on an image data signal, there are an electrophotographic system, sublimation type and melt type thermal transfer systems, an inkjet system, and the like.

With regard to the inkjet system, the printing device using the ink jet system is inexpensive, it is not necessary to use a plate when printing, and since an image is formed directly on a recording medium by discharging an ink composition only on a required image area, the ink composition can be used efficiently and the running cost is low, particularly in the case of small lot production. Further, the printing device using the ink jet system generates little noise and is excellent as an image recording system, and thus, it has been attracting attention in recent years.

Among them, an inkjet recording ink composition (radiation curable inkjet recording ink composition), which is curable upon exposure to radiation such as ultraviolet rays, is a composition in an excellent system, from the viewpoint that the composition has excellent drying properties, as compared with a solvent-based ink composition, an image is resistant to spreading, and therefore, the composition can be printed on various types of recording media since a majority of the components in the ink composition are cured by the irradiation with radiation such as ultraviolet rays.

Examples of ink compositions in the related art include those in JP2012-87298A, JP2002-308935A, EP 1772 498 and EP 2444 429.

### SUMMARY OF THE INVENTION

It is an object of the present invention to provide an inkjet ink composition capable of obtaining a printed material having excellent inkjet dischargeability, excellent flexibility of an image to be obtained, and reduced odor, and an inkjet recording method and a printed material, each using the inkjet ink composition.

The object of the present invention has been attained by means described in <1>, <11>, and <14> below. They are described below together with <2> to <10>, <12> and <13>, which are preferred embodiments.
<1> An inkjet ink composition including (Component A) a polymerizable compound, (Component B) a polymerization initiator, and (Component C) a vegetable oil , in which the component B contains a compound represented by the following formula (1) or (2). 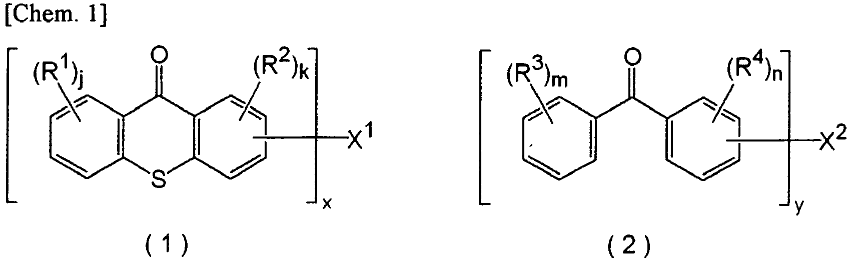
   In the formulae (1) and (2), R¹, R², R³, and R⁴ each independently represent an alkyl group having 1 to 5 carbon atoms, or a halogen atom, x and y each independently represent an integer of 2 to 4, j and m each independently represent an integer of 0 to 4, k and n each independently represent an integer of 0 to 3. When j, k, m, and n are an integer of 2 or more, a plurality of R¹'s, R²'s, R³'s, and R⁴'s may be the same as or different from each other, X¹ represents an x-valent linking group containing at least any one selected from a hydrocarbon chain, an ether bond, and an ester bond, and X² represents a y-valent linking group containing at least any one selected from a hydrocarbon chain, an ether bond, and an ester bond.
<2> The inkjet ink composition as described in <1>, in which the component A contains a polyfunctional (meth)acrylate compound.
<3> The inkjet ink composition as described in <2>, in which the content of the polyfunctional (meth)acrylate compound is 60% by mass or more with respect to the total amount of the inkjet ink composition.
<4> The inkjet ink composition as described in any one of <1> to <3>, in which the component C is a vegetable oil containing saturated fatty acids of 10% by mass or more.
<5> The inkjet ink composition as described in any one of <1> to <4>, in which the iodine value of the component C is 140 or less.
<6> The inkjet ink composition as described in any one of <1> to <5>, in which the content of the component C is 3% by mass to 15% by mass with respect to the total amount of the inkjet ink composition.

<7>The inkjet ink composition as described in any one of <1> to <6>, in which the content of the compound represented by the formula (1) or (2) is 0.01% by mass to 10% by mass with respect to the total amount of the inkjet ink composition.

<8> The inkjet ink composition as described in any one of <1> to <7>, in which the component B further contains a bisacylphosphine compound having a molecular weight of 340 or more.

<9> The inkjet ink composition as described in any one of <1> to <8>, in which a polymerization initiator having a molecular weight of less than 340 is not included as the component B, or the content of the polymerization initiator having a molecular weight of less than 340 is 1% by mass or less with respect to the total amount of the inkjet ink composition.

<10> The inkjet ink composition as described in any one of <1> to <9>, which is used for package printing.

<11> An inkjet recording method including (step a) discharging the inkjet ink composition as described in any one of <1> to <10> onto a support, and (step b) irradiating the inkjet ink composition with active energy rays under an atmosphere of an oxygen partial pressure of 0.1 atm or less to cure the inkjet ink composition in this order.

<12> The inkjet recording method as described in <11>, in which the support is a resin film having a film thickness from 10 µm to 90 µm and containing at least one component selected from the group consisting of polyethylene terephthalate, polyethylene, polypropylene and nylon.

<13> The inkjet recording method as described in <11> or <12>, in which the active energy rays are active energy rays irradiated from LED.

<14> A printed material obtained by the inkjet recording method as described in any one of <11> to <13>.

According to the present invention, an inkjet ink composition capable of obtaining a printed material having excellent inkjet dischargeability, excellent flexibility of an image to be obtained, and reduced odor, and an inkjet recording method and a printed material, each using the inkjet ink composition, are provided.

### BRIEF DESCRIPTION OF THE DRAWING

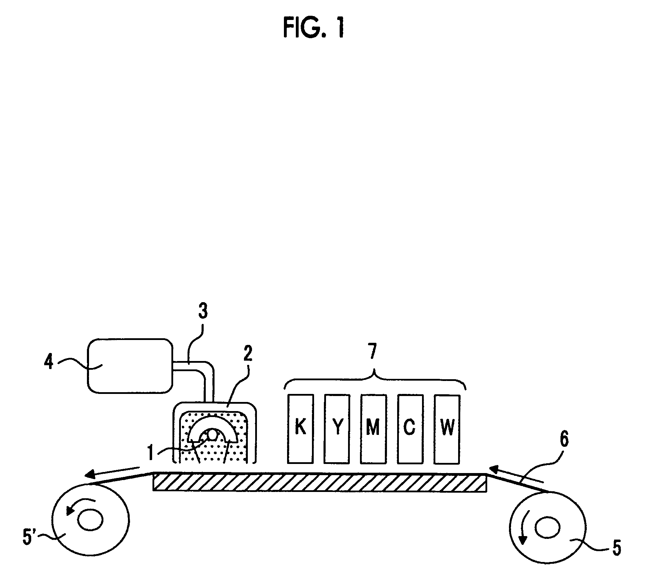

Fig. 1 is a diagram showing an example of the inkjet recording device that is suitably used in the present invention.

### DESCRIPTION OF THE PREFERRED EMBODIMENTS

Further, in the specification, the description of "A to B" denoting a numerical value has the same definition as "from A to B". Further, "(component A) the polymerizable compound" and the like are also simply referred to a "component A" and the like. In addition, "% by mass" and "part(s) by mass" have the same definitions as "% by weight" and "part(s) by weight," respectively.

In addition, in the present invention, when it is intended to indicate both or any one of "acrylate" and "methacrylate", "(meth)acrylate" may be described, and when it is intended to indicate both or any one of "acryl" and "methacryl", "(meth)acryl" may be described.

Hereinbelow, the present invention will be described in detail.

### (Inkjet Ink Composition)

The inkjet ink composition of the present invention (which is also simply referred to as an "ink composition") includes (Component A) a polymerizable compound, (Component B) a polymerization initiator, and (Component C) a vegetable oil selected from the group consisting of olive oil, cacao oil, kapok oil, mustard oil, apricot kernel oil, sesame oil, radish seed oil, soybean oil, chaulmoogra oil, camellia oil, corn oil, rapeseed oil, niger oil, rice bran oil, palm oil, grape seed oil, almond oil, cottonseed oil, coconut oil, and peanut oil, in which the component B contains a compound represented by the following formula (1) or (2).

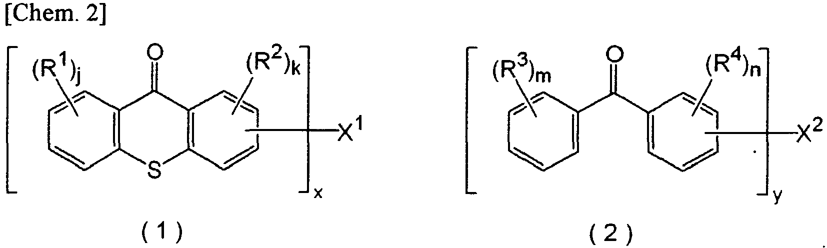

In the formulae (1) and (2), R¹, R², R³, and R⁴ each independently represent an alkyl group having 1 to 5 carbon atoms, or a halogen atom, x and y each independently represent an integer of 2 to 4, j and m each independently represent an integer of 0 to 4, k and n each independently represent an integer of 0 to 3. When j, k, m, and n are an integer of 2 or more, a plurality of R¹'s, R²'s, R³'s, and R⁴'s may be the same as or different from each other. X¹ represents an x-valent linking group containing at least any one selected from a hydrocarbon chain, an ether bond, and an ester bond, and X² represents a y-valent linking group containing at least any one selected from a hydrocarbon chain, an ether bond, and an ester bond.

The ink composition of the present invention is an oily ink composition which is curable with active energy rays. The "active energy ray" is radiation which can provide energy generating initiation species in the ink composition by such irradiation, and includes α rays, γ rays, X rays, ultraviolet rays, visible light, infrared rays, and an electron beam. Among these, from the viewpoints of curing sensitivity and good availability of devices, ultraviolet rays and electron beams are preferred, and ultraviolet rays are more preferred. Although the peak wavelength of the active energy rays depends on the absorption characteristics of a sensitizer, it is preferably, for example, 200 nm to 600 nm, more preferably 300 nm to 450 nm, and still more preferably 320 nm to 420 nm, and the active energy rays are particularly preferably ultraviolet rays having a peak wavelength in the range of 340 nm to 400 nm.

Furthermore, the ink composition of the present invention is an active energy ray-curable ink composition, and is different from an aqueous ink composition or a solvent ink composition. If possible, it is preferable that the ink composition of the present invention do not contain water and a volatile solvent, but if it contains water and a volatile solvent, the content thereof is preferably 1% by mass or less, more preferably 0.5% by mass or less, and still more preferably 0.1% by mass or less, with respect to the total mass of the ink composition.

In addition, the inkjet ink composition of the present invention can be suitably used as an inkjet ink composition for package printing.

Aqueous ink compositions in the related art have a problem that scattering of the ink composition occurs during discharging by inkjet heads in many cases.

Furthermore, the ultraviolet ray-curable ink compositions in the related art have a problem in the flexibility of an image to be obtained although scattering of the ink composition does not occur during inkjet discharging in many cases. In this regard, the present inventors have found that while having an additive improves the flexibility in the related art, dischargeability of the inkjet is deteriorated.

Moreover, printed materials obtained by the inkjet printing of the active energy ray-curable ink compositions in the related art have a problem that the odor of the cured film is strong and the odor is transferred to inclusions or the foods in the vicinity.

The present inventors have conducted intensive studies and as a result, they have found that when the inkjet ink composition of the present invention employs the above-described configuration, a printed material having excellent inkjet dischargeability, excellent flexibility of an image to be obtained, and reduced odor can be obtained.

Hereinafter, the ink composition of the present invention will be described in detail.

### (Component A) Polymerizable Compound

The ink composition of the present invention includes (Component A) a polymerizable compound.

As the polymerizable compound, an ethylenically unsaturated compound is preferred.

As the polymerizable compound, a known polymerizable compound may be used, and examples thereof include a (meth)acrylate compound, a vinyl ether compound, an allyl compound, an N-vinyl compound, and unsaturated carboxylic acids. Examples thereof include radically polymerizable monomers described in JP2009-221414A, polymerizable compounds described in JP2009-209289A, and ethylenically unsaturated compounds described in JP2009-191183A.

As the polymerizable compound, a (meth)acrylate compound is preferred, and an acrylate compound is more preferred.

The ink composition of the present invention preferably includes a polyfunctional (meth)acrylate compound. In the embodiment, a crosslinked structure is formed in a cured film and thus, migration is inhibited.

The content of the polyfunctional (meth)acrylate compound is preferably 60% by mass or more, more preferably 60% by mass to 97% by mass, and still more preferably 65% by mass to 95% by mass, with respect to the total amount of the ink composition. Within the above ranges, curability is excellent and migration is inhibited, and further, adhesion to a substrate is excellent and substrate shrinking is inhibited.

As the polyfunctional (meth)acrylate compound, a polyfunctional (meth)acrylate monomer and/or a polyfunctional (meth)acrylate oligomer is/are preferred, and those containing at least a bifunctional (meth)acrylate compound are more preferred.

In addition, the bifunctional (meth)acrylate compound is preferably a bifunctional acrylate compound, and particularly preferably one having at least a diacrylate monomer.

Preferred examples of the polyfunctional (meth)acrylate compound include di(meth)acrylate compounds (di(meth)acrylate monomers) having 8 to 12 atoms in the main chain.

Further, in the present invention, the monomer refers to a compound having a molecular weight of less than 1,000, and the oligomer is generally a polymer formed by bonding a finite number (generally 5 to 100) of the monomers and has a weight average molecular weight of 1,000 or more.

In addition, in the present invention, the (meth)acrylate monomer means a compound containing one or more (meth)acryloyloxy groups in the molecule and having a molecular weight of less than 1,000.

In the present invention, the molecular weight of the (meth)acrylate monomer is preferably 700 or less, more preferably 500 or less, still more preferably 226 to 358, and particularly preferably 226 to 328. If the molecular weight of the (meth)acrylate monomer is within the above ranges, both of inhibition of migration and odor of the printed material and the reactivity can be satisfied.

Specific preferred examples of the bifunctional (meth)acrylate compound include dipropylene glycol di(meth)acrylate, tetraethylene glycol di(meth)acrylate, neopentyl glycol di(meth)acrylate, 3-methylpentanediol di(meth)acrylate, hexanediol di(meth)acrylate, heptanediol di(meth)acrylate, ethylene oxide(EO) modified neopentyl glycol di(meth)acrylate, propylene oxide (PO) modified neopentyl glycol di(meth)acrylate, EO modified hexanediol di(meth)acrylate, PO modified hexanediol di(meth)acrylate, octanediol di(meth)acrylate, nonanediol di(meth)acrylate, decanediol di(meth)acrylate, dodecanediol di(meth)acrylate, tripropylene glycol di(meth)acrylate, and triethylene glycol di(meth)acrylate.

Moreover, examples of the tri- or higher-functional (meth)acrylate compound include pentaerythritol tri(meth)acrylate, pentaerythritol tetra(meth)acrylate, dipentaerythritol tetra(meth)acrylate, trimethylolethane tri(meth)acrylate, trimethylolpropane tri(meth)acrylate, tetramethylolmethane tetra(meth)acrylate, and oligoester (meth)acrylate.

The ink composition of the present invention may include a polyfunctional (meth)acrylate oligomer.

The oligomer is generally a polymer formed by bonding a finite number (generally 5 to 100) of the monomers, and may be one arbitrarily selected from known oligomers having 2 or more (meth)acryloyloxy groups.

In the present invention, the weight average molecular weight of the polyfunctional (meth)acrylate oligomer is 1,000 or more, preferably 1,000 to 5,000, more preferably 1,500 to 4,500, and particularly preferably 2,000 to 4,000. If the weight average molecular weight is within the above ranges, the migration, odor, and blocking of the cured film are inhibited, and the viscosity of the ink can be within the suitable viscosity range for inkjet.

Furthermore, the weight average molecular weight is 1,000 or more, but in the case where the oligomer has a molecular weight distribution, the content of the components having a molecular weight of 1,000 or less is preferably 5% by mass or less with respect to the entire polyfunctional (meth)acrylate oligomer from the viewpoint of migration inhibition.

The polyfunctional (meth)acrylate oligomer has 2 or more (meth)acryloyloxy groups, and is preferably bi- to hexafunctional, more preferably bi- to tetrafunctional, still more preferably bi- or trifunctional, and particularly preferably bifunctional.

In addition, the polyfunctional (meth)acrylate oligomer is preferably a polyfunctional acrylate oligomer.

As the polyfunctional (meth)acrylate oligomer in the present invention, an oligoester (meth)acrylate is preferred, and among these, a urethane (meth)acrylate, a polyester (meth)acrylate, and an epoxy (meth)acrylate are more preferred, and a urethane (meth)acrylate is still more preferred.

Preferred examples of the urethane (meth)acrylate include an aliphatic urethane (meth)acrylate and an aromatic urethane (meth)acrylate, and more preferred examples thereof include an aliphatic urethane (meth)acrylate.

In addition, as the urethane (meth)acrylate, a tetra- or lower-functional urethane (meth)acrylate is preferred, and a bifunctional urethane (meth)acrylate is more preferred.

When a urethane (meth)acrylate is incorporated, an ink composition having excellent adhesion to a substrate and excellent curability is obtained.

With respect to the component A, Oligomer Handbook (edited by Junji Furukawa, The Chemical Daily Co., Ltd.) may also be referred to.

Further, examples of the commercial products of the polyfunctional (meth)acrylate oligomer include:

Examples of the urethane (meth)acrylates include R1204, R1211, R1213, R1217, R1218, R1301, R1302, R1303, R1304, R1306, R1308, R1901, and R1150 manufactured by Dai-Ichi Kogyo Seiyaku Co., Ltd., EBECRYL series (for example, EBECRYL 230, 270, 4858, 8402, 8804, 8807, 8803, 9260, 1290, 1290K, 5129, 4842, 8210, 210, 4827, 6700, 4450, and 220) manufactured by Daicel-Cytec Co., Ltd., NK Oligo U-4HA, U-6HA, U-15HA, U-108A, and U200AX manufactured by Shin-Nakamura Chemical Co., Ltd., and Aronix M-1100, M-1200, M-1210, M-1310, M-1600, and M-1960 manufactured by Toagosei Co., Ltd.

Examples of the polyester (meth)acrylate include EBECRYL series (for example, EBECRYL 770, IRR 467, 81, 84, 83, 80, 675, 800, 810, 812, 1657, 1810, IRR 302, 450, 670, 830, 870, 1830, 1870, 2870, IRR 267, 813, IRR 483, and 811) manufactured by Daicel-Cytec Co., Ltd. and Aronix M-6100, M-6200, M-6250, M-6500, M-7100, M-8030, M-8060, M-8100, M-8530, M-8560, and M-9050 manufactured by Toagosei Co., Ltd.

In addition, examples of the epoxy (meth)acrylate include EBECRYL series (for example, EBECRYL 600, 860, 2958, 3411, 3600, 3605, 3700, 3701, 3703, 3702, 3708, RDX 63182, and 6040) manufactured by Daicel-Cytec Co., Ltd.

The polyfunctional (meth)acrylate oligomers may be used singly or in combination of two or more kinds thereof.

The content of polyfunctional (meth)acrylate oligomers of the ink composition of the present invention is preferably 15% by mass or less, and more preferably 10% by mass or less, with respect to the total mass of the ink composition.

The ink composition of the present invention may include a monofunctional polymerizable compound as the polymerizable compound. Examples of the monofunctional polymerizable compound include a monofunctional (meth)acrylate compound, a monofunctional (meth)acrylamide compound, a monofunctional aromatic vinyl compound, a monofunctional vinyl ether compound, and a monofunctional N-vinyl compound.

Examples of the monofunctional (meth)acrylate compound include hexyl (meth)acrylate, 2-ethylhexyl (meth)acrylate, tert-octyl (meth)acrylate, isoamyl (meth)acrylate, decyl (meth)acrylate, isodecyl (meth)acrylate, stearyl (meth)acrylate, isostearyl (meth)acrylate, cyclohexyl (meth)acrylate, 4-n-butylcyclohexyl (meth)acrylate, bornyl (meth)acrylate, isobornyl (meth)acrylate, benzyl (meth)acrylate, 2-ethylhexyl diglycol (meth)acrylate, butoxyethyl (meth)acrylate, 2-chloroethyl (meth)acrylate, 4-bromobutyl (meth)acrylate, cyanoethyl (meth)acrylate, benzyl (meth)acrylate, butoxymethyl (meth)acrylate, 3-methoxybutyl (meth)acrylate, 2-(2-methoxyethoxy)ethyl (meth)acrylate, 2-(2-butoxyethoxy)ethyl (meth)acrylate, 2,2,2-tetrafluoroethyl (meth)acrylate, 1H,1H,2H,2H-perfluorodecyl (meth)acrylate, 4-butylphenyl (meth)acrylate, phenyl (meth)acrylate, 2,4,5-tetramethylphenyl (meth)acrylate, 4-chlorophenyl (meth)acrylate, phenoxymethyl (meth)acrylate, phenoxyethyl (meth)acrylate, glycidyl (meth)acrylate, glycidyloxybutyl (meth)acrylate, glycidyloxyethyl (meth)acrylate, glycidyloxypropyl (meth)acrylate, tetrahydrofurfuryl (meth)acrylate, 2-hydroxyethyl (meth)acrylate, 3-hydroxypropyl (meth)acrylate, 2-hydroxypropyl (meth)acrylate, 2-hydroxybutyl (meth)acrylate,

4-hydroxybutyl (meth)acrylate, 3-hydroxybutyl (meth)acrylate, dimethyl aminoethyl (meth)acrylate, diethylaminoethyl (meth)acrylate, dimethylaminopropyl (meth)acrylate, diethylaminopropyl (meth)acrylate, trimethoxysilylpropyl (meth)acrylate, trimethylsilylpropyl (meth)acrylate, polyethylene oxide monomethylether (meth)acrylate, oligoethylene oxide monomethylether (meth)acrylate, polyethylene oxide (meth)acrylate, oligoethylene oxide (meth)acrylate, oligoethylene oxidemonoalkylether (meth)acrylate, polyethylene oxidemonoalkylether (meth)acrylate, dipropylene glycol (meth)acrylate, polypropylene oxidemonoalkylether (meth)acrylate, oligopropylene oxidemonoalkylether (meth)acrylate, 2-methacryloyloxyethylsuccinic acid, 2-methacryloyloxyhexahydrophthalic acid, 2-methacryloyloxyethyl-2-hydroxypropyl phthalate, butoxydiethylene glycol (meth)acrylate, trifluoroethyl (meth)acrylate, perfluorooctylethyl (meth)acrylate, 2-hydroxy-3-phenoxypropyl (meth)acrylate, ethylene oxide (EO) modified phenol (meth)acrylate, EO modified cresol (meth)acrylate, EO modified nonylphenol (meth)acrylate, propylene oxide (PO) modified nonylphenol (meth)acrylate, EO modified-2-ethylhexyl (meth)acrylate, dicyclopentenyl (meth)acrylate, dicyclopentenyloxyethyl (meth)acrylate, dicyclopentanyl (meth)acrylate, (3-ethyl-3-oxetanylmethyl) (meth)acrylate, and phenoxyethylene glycol (meth)acrylate.

Examples of the monofunctional (meth)acrylamide compound include (meth)acrylamide, N-methyl (meth)acrylamide, N-ethyl (meth)acrylamide, N-propyl (meth)acrylamide, N-n-butyl (meth)acrylamide, N-t-butyl (meth)acrylamide, N-butoxymethyl (meth)acrylamide, N-isopropyl (meth)acrylamide, N-methylol (meth)acrylamide, N,N-dimethyl (meth)acrylamide, N,N-diethyl (meth)acrylamide, and (meth)acryloyl morpholine.

Examples of the monofunctional aromatic vinyl compound include styrene, dimethylstyrene, trimethylstyrene, isopropylstyrene, chloromethylstyrene, methoxystyrene, acetoxystyrene, chlorostyrene, dichlorostyrene, bromostyrene, methyl vinylbenzoate ester, 3-methylstyrene, 4-methylstyrene, 3-ethylstyrene, 4-ethylstyrene, 3-propylstyrene, 4-propylstyrene, 3-butylstyrene, 4-butylstyrene, 3-hexylstyrene, 4-hexylstyrene, 3-octylstyrene, 4-octylstyrene, 3-(2-ethylhexyl)styrene, 4-(2-ethylhexyl)styrene, allylstyrene, i sopropenyl styrene, butenylstyrene, octenylstyrene, 4-t-butoxycarbonylstyrene, and 4-t-butoxystyrene.

Moreover, examples of the polymerizable compound used in the present invention include vinyl esters (vinyl acetate, vinyl propionate, and vinyl versatate), allyl esters (allyl acetate), halogen-containing monomers (vinylidene chloride and vinyl chloride), vinyl ether (methylvinyl ether, butylvinyl ether, hexylvinyl ether, methoxyvinyl ether, 2-ethylhexylvinyl ether, methoxyethylvinyl ether, cyclohexylvinyl ether, chloroethylvinyl ether, and triethylene glycol divinyl ether), vinyl cyanide ((meth)acrylonitrile), olefins (ethylene and propylene), and N-vinyl lactams (N-vinyl caprolactam).

Further, examples of the polymerizable compound include unsaturated carboxylic acids such as itaconic acid, crotonic acid, isocrotonic acid, and maleic acid, and salts thereof, and anhydrides having an ethylenically unsaturated group.

More specifically, commercially available or industrially known radically polymerizable or crosslinking monomers, oligomers, and polymers, such as those described in "Kakyozai Handobukku" (Crosslinking Agent Handbook), Ed. S. Yamashita (Taiseisha, 1981); "UV·EB Koka Handobukku (Genryo)" (UV·EB Curing Handbook (Starting Materials)) Ed. Kiyomi Kato (Kobunshi Kankoukai (The Society Polymer Science, Japan), 1985); "UV/EB Koka Gijutsu no Oyo to Shijyo" (Application and Market of UV/EB Curing Technology), p. 79, Ed. RadTech (CMC Publishing Co., Ltd., 1989); and Eiichiro Takiyama "Poriesuteru Jushi Handobukku" (Polyester Resin Handbook), (The Nikkan Kogyo Shimbun Ltd., 1988); and the like may be used.

The polymerizable compounds may be used singly or in combination of two or more kinds thereof.

The content of the polymerizable compound of the ink composition of the present invention is preferably 50% by mass to 95% by mass, more preferably 60% by mass to 95% by mass, and still more preferably 65% by mass to 90% by mass, with respect to the total mass of the ink composition from the viewpoint of curability.

### (Component B) Polymerization Initiator

The ink composition of the present invention includes (Component B) a polymerization initiator, and the component B contains at least a compound represented by the following formula (1) or (2). By using the compound represented by the formula (1) or (2), the amount of the components in the film that elutes (migrates) outside is small and the odor of the printed material is inhibited, and accordingly, an inkjet ink composition having excellent curability and blocking resistance is obtained.

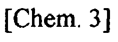

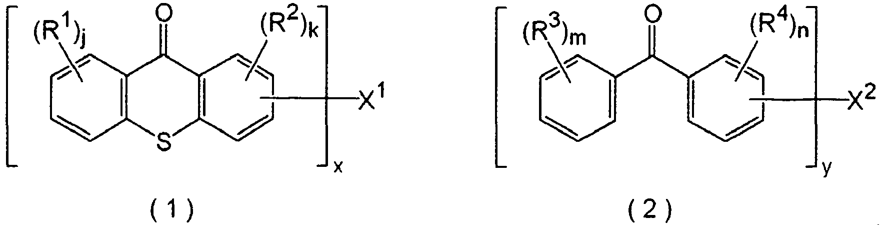

In the formulae (1) and (2), R¹, R², R³, and R⁴ each independently represent an alkyl group having 1 to 5 carbon atoms, or a halogen atom, x and y each independently represent an integer of 2 to 4, j and m each independently represent an integer of 0 to 4, k and n each independently represent an integer of 0 to 3, when j, k, m, and n are an integer of 2 or more, a plurality of R¹'s, R²'s, R³'s, and R⁴'s may be the same as or different from each other. X¹ represents an x-valent linking group containing at least any one selected from a hydrocarbon chain, an ether bond, and an ester bond, and X² represents a y-valent linking group containing at least any one selected from a hydrocarbon chain, an ether bond, and an ester bond.

### <Compound Represented by Formula (1)>

The ink composition of the present invention preferably includes the compound represented by the formula (1) as the component B.

In the formula (1), R¹ and R² each independently represent an alkyl group having 1 to 5 carbon atoms or a halogen atom, in which the alkyl group having 1 to 5 carbon atoms may be any one of linear, branched, and cyclic alkyl groups with a linear or branched alkyl group being preferred, and the alkyl group is preferably an alkyl group having 1 to 4 carbon atoms, and more preferably an alkyl group having 2 or 3 carbon atoms, and still more preferably an ethyl group or an isopropyl group.

Examples of the halogen atom include a fluorine atom, a chlorine atom, a bromine atom, and an iodine atom, and the chlorine atom is preferred.

Among these, R¹ and R² are each independently particularly preferably an ethyl group, an isopropyl group, or a chlorine atom.

In the formula (1), j represents an integer of 0 to 4, preferably 0 to 2, and more preferably 0 or 1. In the case where j is an integer of 2 or more, a plurality of R¹'s may be the same as or different from each other.

In the formula (1), k represents an integer of 0 to 3, preferably 0 to 2, more preferably 0 or 1, and still more preferably 0. In the case where k is an integer of 2 or more, a plurality of R²'s may be the same as or different from each other.

In the formula (1), x represents an integer of 2 to 4, preferably 3 or 4, and more preferably 4.

In the formula (1), X¹ represents an X-valent linking group, containing an x-valent hydrocarbon chain having 2 to 300 carbon atoms, which may contain an ether bond (-O-) and/or an ester bond (-(C=O)-O-).

Further, in the formula (1), there are a plurality (x) of thioxanthone structures, in which X¹ as a linking group is excluded (in the formula (1), a structure represented in [ ]), but the structures may be the same as or different from each other and are not particularly limited. From the viewpoint of synthesis, they are preferably the same as each other.

In the compound represented by the formula (1), the substitution positions to thioxanthone are represented as follows.

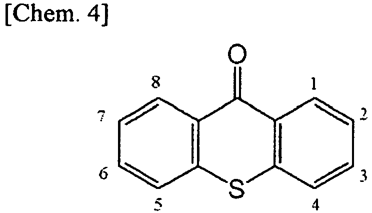

In the case where the substitution positions of X¹ are 1- to 4-positions, the substitution position of X¹ is preferably a 2-, 3-, or 4-position, more preferably a 2- or 4-position, and still more preferably a 4-position.

The substitution position of R¹ is not particularly limited, but is preferably a 6- or 7-position, and more preferably a 6-position.

In addition, the substitution position of R² is not particularly limited, but is preferably a 1-, 2-, or 3-position, and more preferably a 1-position.

The compound represented by the formula (1) is preferably a compound represented by the following formula (1').

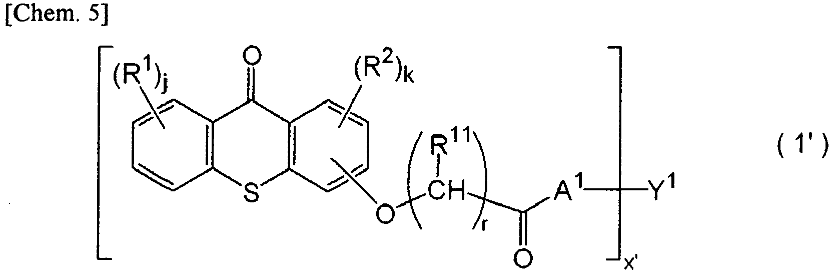

In the formula (1'), R¹, R², j, and k each have the same definitions as R¹, R², j, and k in the formula (1), and the preferred ranges are also the same.

In the formula (1'), R¹¹'s each independently represent a hydrogen atom or an alkyl group having 1 to 4 carbon atoms, preferably a hydrogen atom, a methyl group, or an ethyl group, and more preferably a hydrogen atom.

In the formula (1'), r's each independently represent an integer of 1 to 6, preferably an integer of 1 to 3, more preferably 1 or 2, and still more preferably 1. Further, when r is an integer of 2 or more, a plurality of R¹¹'s may be each the same as or different from each other.

x' represents an integer of 2 to 4, preferably 2 or 3, and more preferably 2.

Y¹ represents a residue formed by excluding hydrogen atoms of x' hydroxyl groups from a polyhydroxy compound having at least x' hydroxyl groups, and preferably a residue formed by excluding hydrogen atoms of all (x') hydroxyl groups from a polyhydroxy compound having x' hydroxyl groups. Specifically, it is preferable a residue formed by excluding hydrogen atoms of x' hydroxyl groups from a polyhydroxy compound selected from the group consisting of ethylene glycol, propylene glycol, butylene glycol, glycerin, trimethylolpropane, ditrimethylolpropane and pentaerythritol, and more preferably a residue formed by excluding hydrogen atoms of all the hydroxyl groups.

In the formula (1'), A¹ represents a group selected from the group consisting of (i) to (iii) below.

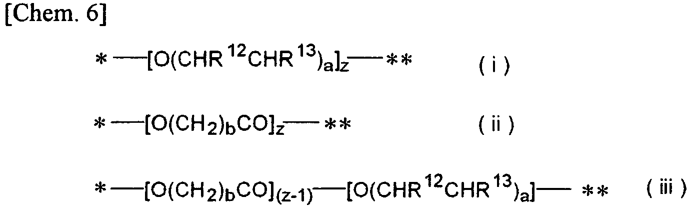

In the formulae (i) to (iii), any one of R¹² and R¹³ represents a hydrogen atom, and the other represents a hydrogen atom, a methyl group, or an ethyl group, a represents an integer of 1 or 2, b represents an integer of 4 or 5, z represents an integer of 1 to 20, * represents a bonding position with carbonyl carbon, and ** represents a bonding position with Y¹.

A¹ is preferably a group represented by the formula (i), and more preferably *-(OCH₂CH₂)_{z}-**, *-(OCH₂CH₂CH₂CH₂)_{z}-**, or *-O(CH(CH₃)CH₂)_{z}-**. In this case, z is more preferably an integer of 3 to 10.

The molecular weight of the compound represented by the formula (1) is preferably 500 to 3,000, more preferably 800 to 2,500, and still more preferably 1,000 to 2,000.

If the molecular weight is 500 or more, elution of the compound from the cured film is inhibited and thus, an ink composition having inhibited migration, odor, and blocking is obtained. On the other hand, if the molecular weight is 3,000 or less, the steric hindrance of the molecules is little and a degree of freedom in a liquid and a film of molecules is maintained, thereby providing high sensitivity.

Further, in the case where the compound represented by the formula (1) is a mixture of a plurality of compounds having different number of carbon atoms, in which the weight average molecular weight is preferably within the above ranges.

Specific examples of the compound represented by the formula (1) are shown below, but the present invention is not limited thereto.

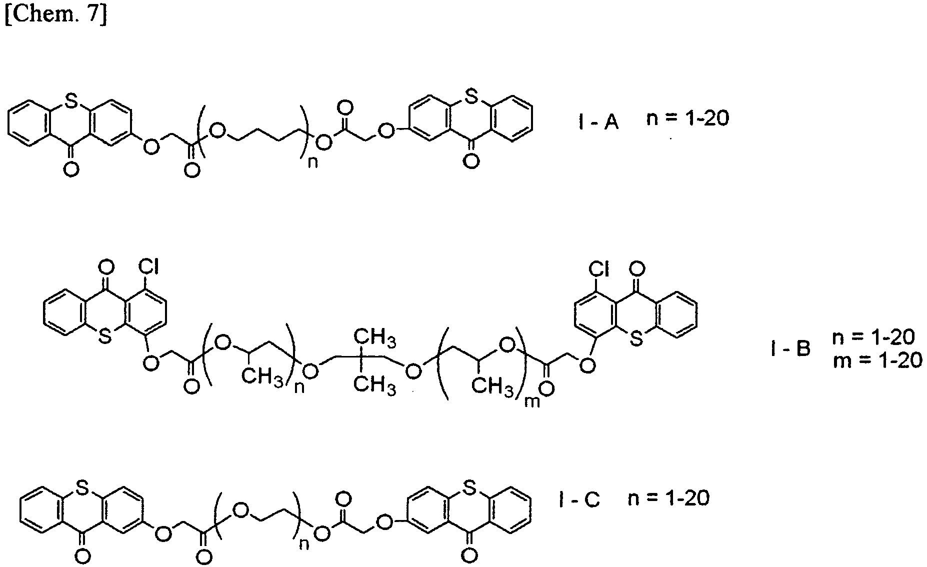

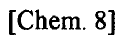

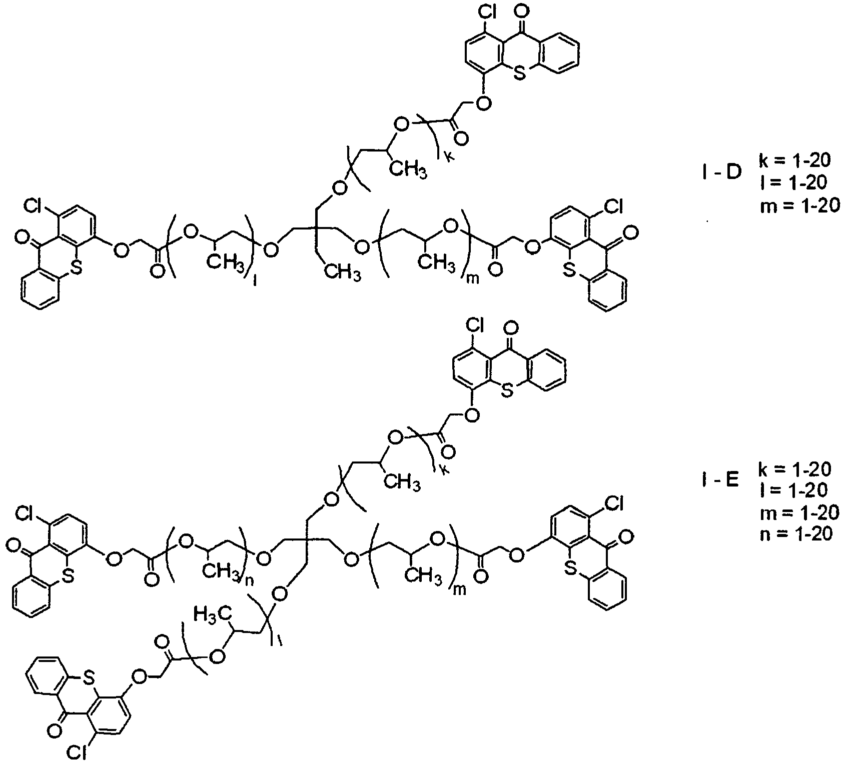

Among these, the compound (I-A), (I-B), or (I-E) is preferred, and the compound (I-B) or (I-E) is more preferred.

As the compound represented by the formula (1), a commerically available compound may be used. Specific examples thereof include SPEEDCURE 7010 (1,3-di({α-[1-chloro-9-oxo-9H-thioxanthen-4-yl]oxy}acetylpoly[oxy(1-methyl ethylene)])oxy) -2,2-bis({α-[1-chloro-9-oxo-9H-thioxanthen-4-yl]oxy}acetylpoly[oxy(1-methylethylene)])oxy methyl)propane, CAS No. 1003567-83-6), and OMNIPOL TX (Polybutylene glycol bis(9-oxo-9H-thioxanthenyloxy)acetate, CAS No. 813452-37-8).

The compound represented by the formula (1) can be prepared by a known reaction, and although not particularly limited, the compound represented by the formula (1') can be prepared, for example, by reacting a compound represented by the following formula (1-1) with a compound represented by the following formula (1-2).

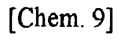

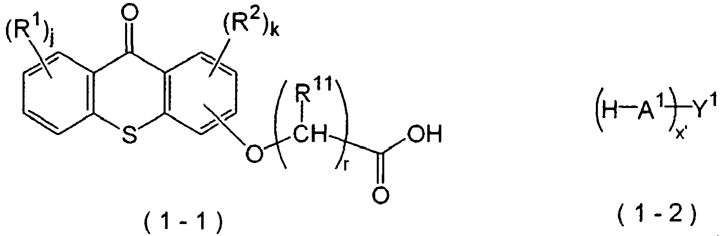

R¹, R², R¹¹, A¹, Y¹, j, k, r, and x' in the formulae (1-1) and (1-2) each have the same definitions as R¹, R², R¹¹, A¹, Y¹, j, k, r, and x' in the formula (1') and the preferred ranges are also the same.

The reaction is preferably carried out in the presence of a solvent and examples of the suitable solvent include aromatic hydrocarbons such as benzene, toluene, and xylene.

Furthermore, the reaction is preferably carried out in the presence of a catalyst, and examples of the catalyst include sulfonic acids (for example, p-toluenesulfonic acid and methane sulfonic acid), inorganic acids (for example, sulfuric acid, hydrochloric acid, and phosphoric acid), and Lewis acids (aluminum chloride, boron trifluoride, and organotitanate).

The reaction temperature and the reaction time are not particularly limited.

After completion of the reaction, isolation is carried out from the reaction mixture by a known means, followed by washing and drying to separate products, if desired.

### <Compound Represented by Formula (2)>

The ink composition of the present invention preferably includes the compound represented by the formula (2) as a component B.

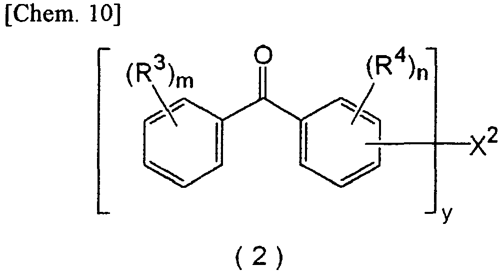

In the formula (2), R³ and R⁴ each independently represent an alkyl group having 1 to 5 carbon atoms, or a halogen atom, m represents an integer of 0 to 4, n represents an integer of 0 to 3, y represents an integer of 2 to 4, when m and n are an integer of 2 or more, a plurality of R³'s and R⁴'s may be the same as or different from each other, and X² represents a y-valent linking group containing at least any one selected from a hydrocarbon chain, an ether bond, and an ester bond.

In the formula (2), R³ and R⁴ each independently represent an alkyl group having 1 to 5 carbon atoms, or a halogen atom, the alkyl group having 1 to 5 carbon atoms may be linear, branched, or cyclic, but is preferably linear or branched, an alkyl group having 1 to 4 carbon atoms is preferred, an alkyl group having 2 or 3 carbon atoms is more preferred, and an ethyl group or an isopropyl group is still more preferred. Examples of the halogen atom include a fluorine atom, a chlorine atom, a bromine atom, and an iodine atom, and the chlorine atom is preferred. R³ and R⁴ are particularly preferably an ethyl group, an isopropyl group, or a chlorine atom.

In the formula (2), m represents an integer of 0 to 4, preferably 0 to 2, and more preferably 0 or 1. In the case where m is an integer of 2 or more, a plurality of R³'s may be the same as or different from each other.

In the formula (2), n represents an integer of 0 to 3, preferably 0 to 2, more preferably 0 or 1, and still more preferably 0. In the case where n is an integer of 2 or more, a plurality of R⁴'s may be the same as or different from each other.

In the formula (2), y represents an integer of 2 to 4, preferably 2 or 3, and more preferably 2.

In the formula (2), X² represents a y-valent linking group containing at least one selected from the group consisting of a hydrocarbon chain, an ether bond (-O-), and an ester bond (-(C=O)-O-).

Further, in the formula (2), there are a plurality (y) of benzophenone structures excluding X² which is a linking group (the structure shown in [ ] in the formula (2)), but they may be the same as or different from each other and are not particularly limited. From the viewpoint of the synthesis, they are preferably the same as each other.

In the compound represented by the formula (2), the substitution positions to benzophenone are represented as shown below.

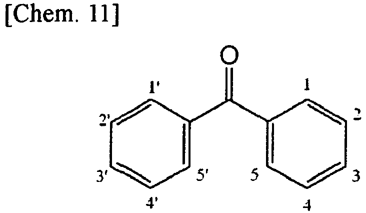

In the case where the substitution position of X² is any of 1- to 5-positions, the substitution position of X² is preferably a 2- or 3-position, and more preferably a 3-position.

The substitution position of R³ is not particularly limited, but is preferably a 2'- or 3'-position, and more preferably a 3'-position.

Furthermore, the substitution position of R⁴ is not particularly limited, but is preferably a 2-, 3-, or 4-position.

The compound represented by the formula (2) is preferably a compound represented by the following formula (2').

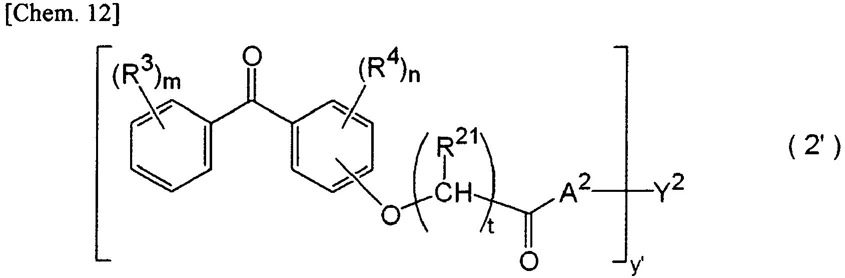

R³, R⁴, m, and n in the formula (2') each have the same definitions as R³, R⁴, m, and n in the formula (2), and the preferred ranges are also the same.

In the formula (2'), R²¹'s each independently represent a hydrogen atom or an alkyl group having 1 to 4 carbon atoms, preferably a hydrogen atom, a methyl group, or an ethyl group, and more preferably a hydrogen atom.

In the formula (2'), t's each independently represent an integer of 1 to 6, preferably an integer of 1 to 3, more preferably 1 or 2, and still more preferably 1. Further, when t is an integer of 2 or more, a plurality of R²¹'s may be the same as or different from each other.

y' represents an integer of 2 to 4, preferably 2 or 3, and more preferably 2.

Y² represents a residue formed by excluding hydrogen atoms of y' hydroxyl groups from a polyhydroxy compound having at least y' hydroxyl groups, and preferably a residue formed by excluding hydrogen atoms of all (y') hydroxyl groups from a polyhydroxy compound having y' hydroxyl groups. Specifically, it is preferable a residue formed by excluding hydrogen atoms of y' hydroxyl groups from a polyhydroxy compound selected from the group consisting of ethylene glycol, propylene glycol, butylene glycol, glycerin, trimethylolpropane, ditrimethylolpropane, and pentaerythritol, and more preferably a residue formed by excluding hydrogen atoms of all hydroxyl groups.

In the formula (2'), A² represents a group selected from the group consisting of the following formulae (i) to (iii).

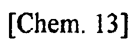

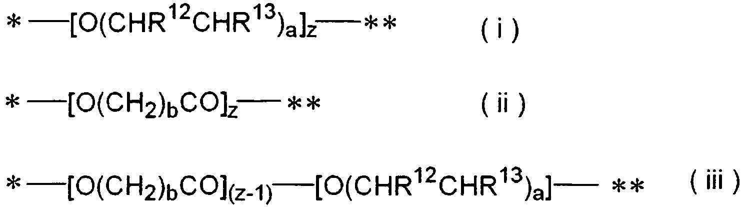

In the formulae (i) to (iii), any one of R¹² and R¹³ represents a hydrogen atom, the other represents a hydrogen atom, a methyl group, or an ethyl group, a represents an integer of 1 or 2, b represents an integer of 4 or 5, and z represents an integer of 1 to 20. Further, * represents a bond position with carbonyl carbon, and ** represents a bond position with Y².

A² is preferably a group represented by the formula (i), and more preferably *-(OCH₂CH₂)_{z}-**, *-(OCH₂CH₂CH₂CH₂)_{z}-**, or *-O(CH(CH₃)CH₂)_{z}-**. In this case, z is more preferably an integer of 3 to 10.

The molecular weight of the compound represented by the formula (2) is preferably 500 to 3,000, more preferably 800 to 2,500, and still more preferably 1,000 to 2,000.

If the molecular weight is 500 or more, an ink composition, in which the elution of the compound from the cured film is inhibited, and thus migration, odor and blocking are inhibited, is obtained. On the other hand, if the molecular weight is 3,000 or less, the steric hindrance of the molecules is little and a degree of freedom in a liquid and a film of molecules is maintained, thereby providing high sensitivity.

Further, in the case where the compound represented by the formula (2) is a mixture of a plurality of compounds having different number of carbon atoms, in which the weight average molecular weight is preferably within the above ranges.

Specific examples of the compound represented by the formula (2) are shown below, but the present invention is not limited thereto.

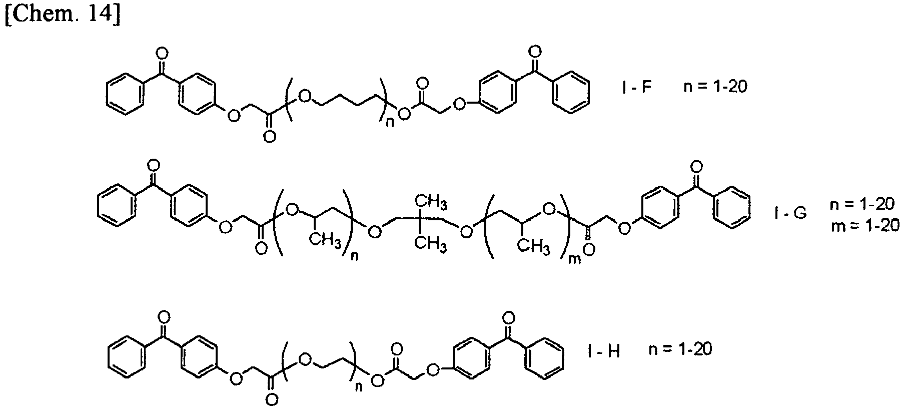

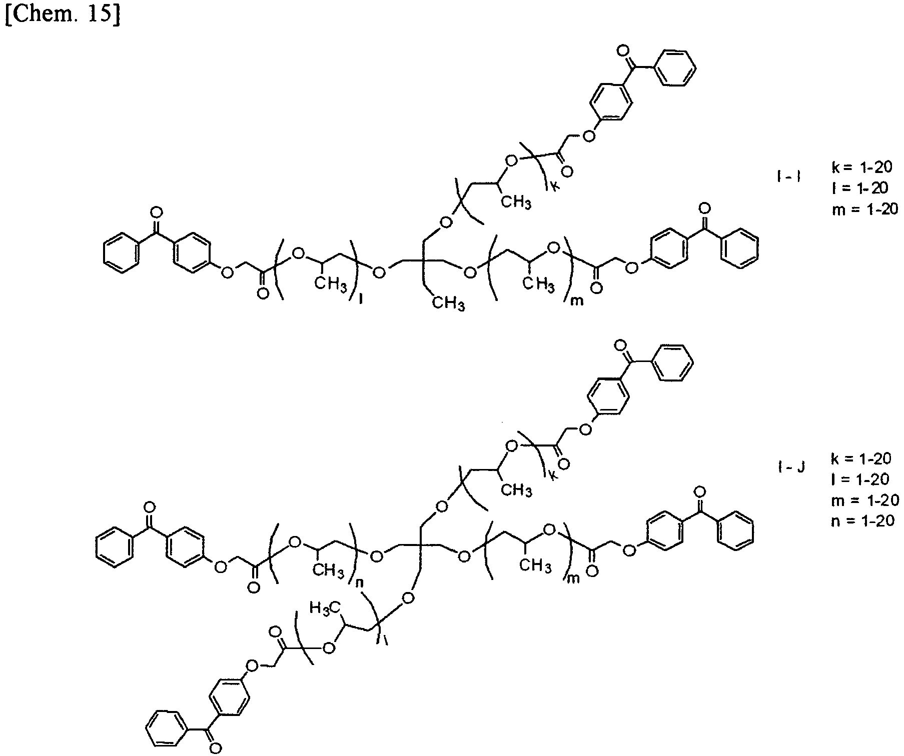

As the compound represented by the formula (2), a commerically available compound may be used. Specific examples thereof include OMNIPOL BP (Polybutylene glycol bis(4-benzoylphenoxy)acetate, CAS No. 515136-48-8).

The compound represented by the formula (2) can be prepared by a known reaction, and although not particularly limited, the compound represented by the formula (2') can be prepared, for example, by reacting a compound represented by the following formula (2-1) with a compound represented by the following formula (2-2).

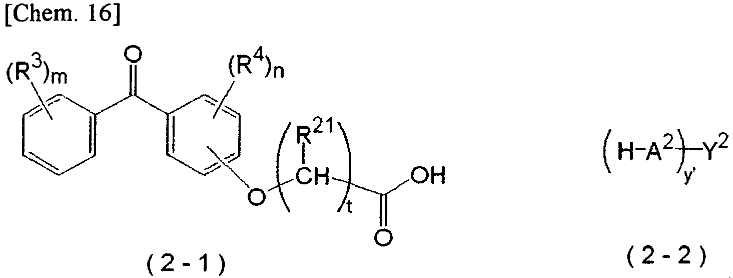

R³, R⁴, R²¹, A², Y², m, n, t, and y' in the formulae (2-1) and (2-2) each have the same definitions as R³, R⁴, R²¹, A², Y², m, n, t, and y' in the formula (2') and the preferred range are also the same.

The reaction is preferably carried out in the presence of a solvent and examples of the suitable solvent include aromatic hydrocarbons such as benzene, toluene, and xylene.

Furthermore, the reaction is preferably carried out in the presence of a catalyst, and examples of the catalyst include sulfonic acids (for example, p-toluenesulfonic acid and methane sulfonic acid), inorganic acids (for example, sulfuric acid, hydrochloric acid, and phosphoric acid), and Lewis acids (aluminum chloride, boron trifluoride, and organotitanate).

The reaction temperature and the reaction time are not particularly limited.

After completion of the reaction, isolation is carried out from the reaction mixture by a known means, followed by washing and drying to separate products, if desired.

The content of the compound represented by the formula (2) is preferably 1% by mass to 5% by mass, and more preferably 2% by mass to 4% by mass, with respect to the total amount of the ink composition, from the viewpoints of high sensitivity, and inhibition of migration, odor, and blocking.

Furthermore, the compound represented by the formula (2) is more preferably a compound represented by the formula (2-1).

The content of the compound represented by the formula (1) or (2) is preferably 0.01% by mass to 10% by mass, more preferably 0.05% by mass to 8.0% by mass, still more preferably 0.1% by mass to 5.0% by mass, and particularly preferably 0.1% by mass to 2.4% by mass, with respect to the total amount of the ink composition. Within the above ranges, the curability is excellent.

### <Polymerization Initiator Other Than Compound Represented by Formula (1) or (2)>

The ink composition of the present invention may further include a polymerization initiator other than the compound represented by the formula (1) or (2).

The ink composition of the present invention preferably further includes a polymerization initiator having a molecular weight of 340 or more, which is other than the compound represented by the formula (1) or (2), and more preferably a bisacylphosphine compound having a molecular weight of 340 or more.

In the ink composition of the present invention, the preferable content of the polymerization initiator having a molecular weight of less than 340 is zero, or more than 0% by mass and 1% by mass or less, preferably zero, or more than 0% by mass and 0.5% by mass or less, more preferably zero, or more than 0% by mass and 0.3% by mass or less, and particularly preferably zero, with respect to the total amount of the ink composition, from the viewpoint of inhibition of migration, odor, and blocking.

Examples of the polymerization initiator other than the compound represented by the formula (1) or (2) include (a) aromatic ketones, (b) acylphosphine compounds, (c) aromatic onium salt compounds, (d) organic peroxides, (e) thio compounds, (f) hexaarylbiimidazole compounds, (g) ketoxime ester compounds, (h) borate compounds, (i) azinium compounds, (j) metallocene compounds, (k) active ester compounds, (I) compound having carbon-halogen bonds, and (m) alkylamine compounds. With regard to these radical polymerization initiators, the compounds (a) to (m) may be used singly or in combination. Details of the above-mentioned polymerization initiators are described in for example paragraphs 0090 to 0116 of JP2009-185186A.

The polymerization initiators of the present invention may be used singly or in combination of two or more kinds thereof.

Examples of the polymerization initiator other than the compound represented by the formula (1) or (2) include an acylphosphine compound, an α-hydroxyketone compound, and/or an α-aminoketone compound.

Among these, the acylphosphine compound and/or the α-aminoketone compound is/are preferred, and the acylphosphine compound is more preferred.

Suitable examples of the acylphosphine compound include bisacylphosphine compounds such as bis(2,4,6-trimethylbenzoyl)phenylphosphine oxide, bis(2,6-dimethylbenzoyl)phenylphosphine oxide, bis(2,4,6-trimethylbenzoyl)-2-methoxyphenylphosphine oxi de, bis(2,6-dimethylbenzoyl)-2-methoxyphenylphosphine oxide, bis(2,4,6-trimethylbenzoyl)-2,4-dimethoxyphenylphosphine oxide, bis(2,6-dimethylbenzoyl)-2,4-dimethoxyphenylphosphine oxide, bis(2,4,6-trimethylbenzoyl)-2,4-dipentyloxyphenylphosphine oxide, and bis(2,6-dimethylbenzoyl)-2,4-dipentyloxyphenylphosphine oxide; 2,4,6-trimethylbenzoylethoxyphenylphosphine oxide, 2,6-dimethylbenzoylethoxyphenylphosphine oxide, 2,4,6-trimethylbenzoylmethoxyphenylphosphine oxide, 2,6-dimethylbenzoylmethoxyphenylphosphine oxide, 2,4,6-trimethylbenzoyl(4-pentyloxyphenyl)phenylphosphine oxide, and 2,6-dimethylbenzoyl(4-pentyloxyphenyl)phenylphosphine oxide.

Among these, as the acylphosphine oxide compound, bis(2,4,6-trimethylbenzoyl)phenylphosphine oxide(IRGACURE 819, manufactured by BASF Japan), and bis(2,6-dimethoxybenzoyl)-2,4,4-trimethylpentylphenylphosphine oxide are preferred, and bis(2,4,6-trimethylbenzoyl)phenylphosphine oxide is particularly preferred.

Furthermore, as the polymerization initiator other than the compound represented by the formula (1) or (2), aromatic ketones are preferred from the viewpoint of curability.

As the aromatic ketones, an α-hydroxyketone compound and/or an α-aminoketone compound is/are preferred.

As the α-hydroxyketone compound, known ones may be used, but examples thereof include 1-[4-(2-hydroxyethoxy)phenyl]-2-hydroxy-2-methyl-1-propan-1-one, 2-hydroxy-2-methyl-1-phenylpropan-1-one, and 1-hydroxycyclohexylphenylketone, and among these, a 1-hydroxycyclohexylphenylketone compound is preferred. Further, in the present invention, examples of the 1-hydroxycyclohexylphenylketone compound include a compound having 1-hydroxycyclohexylphenylketone substituted with an arbitrary substituent. The substituent may be arbitrarily selected from the range in which the ability of a radical polymerization initiator can be exerted, and specific examples thereof include an alkyl group having 1 to 4 carbon atoms.

Furthermore, as the α-aminoketone compound, a known α-aminoketone compound may be used, and specific examples thereof include 2-methyl-1-phenyl-2-morpholinopropan-1-one, 2-methyl-1-(4-hexylphenyl)-2-morpholinopropan-1-one, 2-ethyl-2-dimethylamino-1-(4-morpholinophenyl)-butan-1-one, 2-methyl-1-(4-methylthiophenyl)-2-morpholinopropan-1-one, 2-benzyl-2-dimethylamino-1-(4-morpholinophenyl)butan-1-one, 2-benzyl-2-dimethyl amino-1-(4-dimethylaminophenyl)-butan-1-one, and 2-dimethylamino-2-[(4-methylphenyl)methyl]-1-[4-(4-morpholinyl)phenyl]butan-1-one. Further, preferred examples of the commercially available product include IRGACURE 907, IRGACURE 369, and IRGACURE 379, all manufactured by BASF Japan.

In addition, examples of the polymerization initiator include SPEEDCURE 7040 manufactured by LAMB SON and LUCIRIN TPO manufactured by BASF.

As a polymerization initiator, the ink composition of the present invention preferably contains a compound which serves as a sensitizer in order to promote the decomposition of the polymerization initiator by absorbing specific active energy rays (hereinafter also referred to as a "sensitizer").

Examples of the sensitizer include polynuclear aromatic compounds (for example, pyrene, perylene, triphenylene, and 2-ethyl-9,10-dimethoxyanthracene), xanthenes (for example, fluorescein, eosin, erythrosine, rhodamine B, and rose bengal), cyanines (for example, thiacarbocyanine and oxacarbocyanine), merocyanines (for example, merocyanine and carbomerocyanine), thiazines (for example, thionine, methylene blue, and toluidine blue), acridines (for example, acridine orange, chloroflavin, and acriflavine), anthraquinones (for example, anthraquinone), squaryliums (for example, squarylium), coumarins (for example, 7-diethylamino-4-methylcoumarin), thioxanthones (for example, isopropylthioxanthone), and thiochromanones (for example, thiochromanone).

Among these, as the sensitizer, thioxanthones are preferred, and isopropylthioxanthone is more preferred.

Further, the sensitizers may be used singly or in a combination of two or more kinds thereof.

The total content of the polymerization initiator is preferably 1.0% by mass to 15.0% by mass, more preferably 1.5% by mass to 10.0% by mass, and still more preferably 1.5% by mass to 7.0% by mass, with respect to the total amount of the ink composition. Within the above ranges, the curability is excellent.

### (Component C) Vegetable Oil

The ink composition of the present invention includes a (Component C) vegetable oil. When the vegetable oil is included, flexibility of an image to be obtained and adhesion to a support are excellent, and the odor is inhibited, and further, the inkjet dischargeability is excellent.

The vegetable oil is a triglyceride having glycerin and fatty acid, in which at least one of fatty acids is a fatty acid having at least one ethylenically unsaturated bond, and if its chemical structure is the structure above, it may be any one of natural oil derived from plants, synthetic oil, and modified oil, as described below.

Specific examples of the vegetable oil include olive oil, cacao oil, kapok oil, mustard oil, apricot kernel oil, sesame oil, radish seed oil, soybean oil, chaulmoogra oil, camellia oil, corn oil, rapeseed oil, niger oil, rice bran oil, palm oil grape seed oil, almond oil, cottonseed oil, coconut oil and peanut oil.

The vegetable oil used in the present invention may be used singly or in combination of two or more kinds thereof.

The amount of saturated fatty acids in the component C is preferably 5% by mass or more, and more preferably 10% by mass or more, and further, preferably 50% by mass or less, and more preferably 30% by mass or less. Within the above ranges, the adhesion to a support is more excellent and the odor can be further inhibited.

Further, the amount of saturated fatty acids is a content of the saturated fatty acids with respect to the total amount of the fatty acids included in the component C.

A method for measuring the amount of saturated fatty acids is not particularly limited, and can be calculated by analysis of components and structures by a known method.

The iodine value of the component C in the ink composition of the present invention is preferably 160 or less, more preferably 140 or less, still more preferably 100 to 140, and particularly preferably 100 or more and less than 130. Within the above ranges, the adhesion to a support is excellent and the odor can be further inhibited.

Further, the iodine value denotes the amount in gram of iodine that reacts with 100 g of a sample. Preferred examples of the method for measuring the iodine value include a method based on JIS K0070.

Furthermore, the component C may be any one of a non-dry oil having an iodine value of less than 100, a semi-dry oil having an iodine value of 100 or more and less than 130, and a dry oil having an iodine value of 130 or more, but it is preferably the non-dry oil or the semi-dry oil.

Specific examples thereof include the following ones. Further, the iodine values are listed in the parentheses and denoted as values cited from Handbook of Oleochemical Products: Nikkan Kogyo Shimbun, Ltd., or measured values:

olive oil (70-90),cacao oil (5-40), kapok oil (85-102), mustard oil (101 or more), apricot kernel oil (97-109), sesame oil (104 or more), radish seed oil (98-112), soybean oil (114-138), chaulmoogra oil (101), camellia oil (78-88), corn oil (103-130), rapeseed oil (97-107), niger oil (126 or more), rice bran oil (92-115), palm oil (43-60), grape seed oil (124 or more), almond oil (93 to 105), cottonseed oil (102-120), coconut oil (7-11) and peanut oil (84-102).

The fatty acids constituting the vegetable oil are not particularly limited, but preferred examples thereof include lauric acid, myristic acid, palmitic acid, palmitoleic acid, stearic acid, oleic acid, 12-hydroxystearic acid, tall acid, isostearic acid, linoleic acid, α-linolenic acid, and γ-linolenic acid.

Among these, more preferred examples of the component C include vegetable oils selected from the group consisting of mustard oil, sesame oil, soybean oil, chaulmoogra oil, corn oil, niger oil, grape seed oil, and cottonseed oil; and still more preferred examples of the component C include vegetable oils selected from the group consisting of sesame oil, soybean oil, corn oil, niger oil, grape seed oil, and cottonseed oil.

The content of (Component C) vegetable oil in the ink composition of the present invention is preferably 0.5% by mass to 30% by mass, more preferably 1% by mass to 25% by mass, still more preferably 2% by mass to 20% by mass, particularly preferably 3% by mass% by mass to 15% by mass, and most preferably 4% by mass to 12% by mass, with respect to the total mass of the ink composition,. Within the above ranges, inkjet dischargeability, adhesion to a support, and flexibility of an image to be obtained are more excellent.

### (Component D) Colorant

In order to improve the visibility of the formed image area, the ink composition of the present invention preferably includes a colorant.

The colorant is not particularly limited, but a pigment and an oil-soluble dye that have excellent weather resistance and rich color reproduction are preferred, and any one arbitrarily selected from known colorants such as an oil-soluble dye may be used. For the colorant, a compound which does not function as a polymerization inhibitor is preferably chosen from the viewpoint of not reducing the sensitivity of a curing reaction by active energy rays.

The pigment that can be used in the present invention is not particularly limited, but, for example, organic or inorganic pigments having the numbers below described in the Color Index may be used.

That is, as a red or magenta pigment, Pigment Red 3, 5, 19, 22, 31, 38, 42, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, and 257, Pigment Violet 3, 19, 23, 29, 30, 37, 50, and 88, Pigment Orange 13, 16, 20, and 36; as a blue or cyan pigment, Pigment Blue 1, 15, 15:1, 15:2, 15:3, 15:4, 15:6, 16, 17-1, 22, 27, 28, 29, 36, and 60; as a green pigment, Pigment Green 7, 26, 36, and 50; as a yellow pigment, Pigment Yellow 1, 3, 12, 13, 14, 17, 34, 35, 37, 55, 74, 81, 83, 93, 94, 95, 97, 108, 109, 110, 120, 137, 138, 139, 153, 154, 155, 157, 166, 167, 168, 180, 185, and 193; as a black pigment, Pigment Black 7, 28, and 26; and as a white pigment, Pigment White 6, 18, and 21, or the like may be used according to the purpose.

In the present invention, a disperse dye may also be used in a range that enables it to be dissolved in a water-immiscible organic solvent. Disperse dyes generally include water-soluble dyes, but in the present invention, it is preferable for the disperse dye to be used in a range in which it dissolves in a water-immiscible organic solvent.

Specific preferred examples of the disperse dye include C. I. Disperse Yellow 5, 42, 54, 64, 79, 82, 83, 93, 99, 100, 119, 122, 124, 126, 160, 184:1, 186, 198, 199, 201, 204, 224, and 237; C. I. Disperse Orange 13, 29, 31:1, 33, 49, 54, 55, 66, 73, 118, 119, and 163; C. I. Disperse Red 54, 60, 72, 73, 86, 88, 91, 92, 93, 111, 126, 127, 134, 135, 143, 145, 152, 153, 154, 159, 164, 167:1, 177, 181, 204, 206, 207, 221, 239, 240, 258, 277, 278, 283, 311, 323, 343, 348, 356, and 362; C. I. Disperse Violet 33; C. I. Disperse Blue 56, 60, 73, 87, 113, 128, 143, 148, 154, 158, 165, 165:1, 165:2, 176, 183, 185, 197, 198, 201, 214, 224, 225, 257, 266, 267, 287, 354, 358, 365, and 368; and C. I. Disperse Green 6:1 and 9.

It is preferable that the colorant be added to the ink composition and then dispersed in the ink composition to an appropriate degree. For dispersion of the colorant, for example, a dispersing machine such as a ball mill, a sand mill, an attritor, a roll mill, an agitator, a Henschel mixer, a colloidal mill, an ultrasonic homogenizer, a pearl mill, a wet type jet mill, and a paint shaker may be used.

The colorant may be added directly together with the respective components in the preparation of the ink composition. Further, in order to improve dispersibility, it may be added in advance to a solvent or a dispersing medium such as a polymerizable compound used in the present invention, and uniformly dispersed or dissolved, and then blended.

In the present invention, in order to avoid the problem that the solvent resistance is degraded when the solvent remains in the cured image and the VOC (Volatile Organic Compound) problem of the residual solvent, it is preferable to add the colorant in advance to a dispersing medium such as a polymerizable compound and blend them. As a polymerizable compound used for the addition of the colorant, it is preferable in terms of dispersion suitability to select a monomer having a low viscosity. The colorants may be used by appropriately selecting one kind or two or more kinds according to the intended purpose of the ink composition.

Moreover, when a colorant which exist in a state of solid in the ink composition is used, it is preferable to select a colorant, a dispersant, and a dispersing medium, and set the dispersion conditions and the filtration conditions so that the average particle size of colorant particles may be preferably 0.005 µm to 0.5 µm, more preferably 0.01 µm to 0.45 µm, and still more preferably 0.015 µm to 0.4 µm. By controlling the particle size, clogging of a head nozzle can be inhibited, and the storage stability, the transparency, and the curing sensitivity of the ink composition can be maintained.

The content of the colorant in the ink composition is appropriately selected according to the color and the intended purpose, but is preferably from 0.01% by mass to 30% by mass with respect to the total mass of the ink composition.

### (Component E) Dispersant

The ink composition of the present invention preferably includes a dispersant. In particular, in a case of using a pigment, the ink composition preferably contains a dispersant in order to stably disperse the pigment in the ink composition. As the dispersant, a polymeric dispersant is preferred. Further, the "polymeric dispersant" in the present invention means a dispersant having a weight average molecular weight of 1,000 or more.

Examples of the polymeric dispersant include polymeric dispersants such as DISPERBYK-101, DISPERBYK-102, DISPERBYK-103, DISPERBYK-106, DISPERBYK-111, DISPERBYK-161, DISPERBYK-162, DISPERBYK-163, DISPERBYK-164, DISPERBYK-166, DISPERBYK-167, DISPERBYK-168, DISPERBYK-170, DISPERBYK-171, DISPERBYK-174, and DISPERBYK-182 (manufactured by BYK Chemie), EFKA4010, EFKA4046, EFKA4080, EFKA5010, EFKA5207, EFKA5244, EFKA6745, EFKA6750, EFKA7414, EFKA745, EFKA7462, EFKA7500, EFKA7570, EFKA7575, and EFKA7580 (manufactured by EFKA Additives), Disperse Aid 6, Disperse Aid 8, Disperse Aid 15, and Disperse Aid 9100 (manufactured by San Nopco Limited); various types of SOLSPERSE dispersants such as Solsperse 3000, 5000, 9000, 12000, 13240, 13940, 17000, 22000, 24000, 26000, 28000, 32000, 36000, 39000, 41000, and 71000 (manufactured by Lubrizol Corporation); Adeka Pluronic L31, F38, L42, L44, L61, L64, F68, L72, P95, F77, P84, F87, P94, L101, P103, F108, L121, and P-123 (manufactured by Adeka Corporation), Ionet S-20 (manufactured by Sanyo Chemical Industries, Ltd.), and Disparlon KS-860, 873SN, and 874 (polymeric dispersant), #2150 (aliphatic poly carboxylic acid), and #7004 (polyether ester type) (manufactured by Kusumoto Chemicals, Ltd.).

The content of the dispersant in the ink composition of is appropriately selected based on how the ink composition is used, and is preferably 0.05% by mass to 15% by mass with respect to the total amount of the ink composition.

### (Component F) Surfactant

A surfactant may be added to the ink composition of the present invention in order to impart stable dischargeability for a long period of time.

Examples of the surfactant include those described in each of JP1987-173463A (JP-S62-173463A) and JP1987-183457A (JP-S62-183457A). Examples thereof include anionic surfactants such as dialkylsulfosuccinate, alkylnaphthalene sulfonate, and fatty acid salts, nonionic surfactants such as polyoxyethylene alkyl ethers, polyoxyethylene alkyl allyl ethers, acetylene glycols, and polyoxyethylene/polyoxypropylene block copolymers, and cationic surfactants such as alkylamine salts and quaternary ammonium salts. Further, fluorine-based surfactants (for example, organofluoro compounds) or silicone-based surfactants (for example, polysiloxane compounds) may be used as the surfactant. The organofluoro compound is preferably hydrophobic. Examples of the organofluoro compound include fluorine-based surfactants, oil-like fluorine-based compounds (for example, a fluorine oil), solid fluorine compound resins (for example, a tetrafluoroethylene resin), and those described in JP1982-9053B (JP-S57-9053B) (paragraphs 8 to 17) and JP1987-135826A (JP-S62-135826A).

As the polysiloxane compound, a modified polysiloxane compound in which an organic group is introduced into some methyl groups of dimethyl polysiloxane is preferable. Modification examples include polyether modification, methylstyrene modification, alcohol modification, alkyl modification, aralkyl modification, fatty acid ester modification, epoxy modification, amine modification, amino modification, and mercapto modification, but are not limited thereto. These methods for modification may be used in combination. Further, among them, polyether-modified polysiloxane compounds are preferable from the viewpoint of improvement in inkjet discharge stability.

Examples of the polyether-modified polysiloxane compounds include SILWET L-7604, SILWET L-7607N, SILWET FZ-2104, and SILWET FZ-2161 (manufactured by Nippon Unicar Co., Ltd.), BYK-306, BYK-307, BYK-331, BYK-333, BYK-347, and BYK-348 (manufactured by BYK Chemie), and KF-351A, KF-352A, KF-353, KF-354L, KF-355A, KF-615A, KF-945, KF-640, KF-642, KF-643, KF-6020, X-22-6191, X-22-4515, KF-6011, KF-6012, KF-6015, and KF-6017 (manufactured by Shin-Etsu Chemical Co., Ltd.).

Among these, preferred examples of the surfactant include silicone-based surfactants.

The content of the surfactant in the ink composition of the present invention is appropriately selected based on how the ink composition is used, and is preferably 0.0001% by mass to 1% by mass with respect to the total amount of the ink composition.

### <Other Components>

The ink composition of the present invention may include other components as necessary. Thus, in addition to the respective components as described above, a surfactant, a cosensitizer, an ultraviolet ray absorber, an antioxidant, an antifading agent, a conductive salt, a solvent, a polymeric compound, a basic compound, or the like may be included. As the other components, known components may be used. Examples include the components described in JP2009-221416A.

Furthermore, from the viewpoint of storage properties and inhibition of head clogging, the ink composition of the present invention preferably includes a polymerization inhibitor.

The content of the polymerization inhibitor is preferably 200 ppm to 20,000 ppm with respect to the total mass of the ink composition of the present invention.

Examples of the polymerization inhibitor include a nitroso-based polymerization inhibitor, a hindered amine-based polymerization inhibitor, hydroquinone, benzoquinone, p-methoxyphenol, TEMPO, TEMPOL, and cupferron A1.

### < Ink Properties >

In the present invention, the ink composition has a viscosity at 25°C of preferably 40 mPa·s or less, more preferably 5 mPa·s to 40 mPa·s, and still more preferably 7 mPa·s to 30 mPa·s, taking into consideration dischargeability. Further, the viscosity of the ink composition at the discharge temperature (preferably 25°C to 80°C, and more preferably 25°C to 50°C) is preferably 3 mPa·s to 15 mPa·s, and more preferably 3 mPa·s to 13 mPa·s. With regard to the ink composition of the present invention, it is preferable that its component ratio be appropriately adjusted such that the viscosity is in the above-specified ranges. By setting the viscosity at room temperature (25°C) to be high, even when a porous recording medium (support) is used, penetration of the ink composition into the recording medium can be avoided and the amount of uncured monomers can be reduced. In addition, ink blurring when the liquid droplets of ink composition have landed can be inhibited, and as a result, the image quality is improved, which is preferable.

The surface tension at 25°C of the ink composition of the present invention is preferably from 20 mN/m to 40 mN/m, more preferably from 20.5 mN/m to 35.0 mN/m, still more preferably from 21 mN/m to 30.0 mN/m, and particularly preferably from 21.5 mN/m to 28.0 N/m. Within the above ranges, a printed material having excellent blocking resistance is obtained.

Further, as a method for measuring the surface tension at 25°C of the ink composition, a known method may be used, but a ring building method or a Wilhelmy method is preferably used for the measurement. The preferred examples of the measurement methods include a measurement method using an automatic surface tensiometer, CBVP-Z, manufactured by Kyowa Interface Science Co., Ltd., and a measurement method using SIGMA 702 manufactured by KSV Instruments Ltd.

### (Inkjet Recording Method, Inkjet Recording Device, and Printed Material)

The inkjet recording method of the present invention is a method in which the inkjet ink composition of the present invention is discharged onto a recording medium (hereinafter also referred as a "substrate" or a "support") for inkjet recording, and the inkjet ink composition discharged onto the recording medium is irradiated with active energy rays to cure the inkjet ink composition, thereby forming an image. It is preferably a method in which the inkjet ink composition of the present invention is discharged onto a recording medium for inkjet recording, the inkjet ink composition discharged onto the recording medium is irradiated with active energy rays under a low oxygen partial pressure to cure the inkjet ink composition, thereby forming an image.

More specifically, the inkjet recording method of the present invention preferably includes (step a) discharging the ink composition onto a support, and (step b) irradiating the ink composition with active energy rays to cure the ink composition, and more preferably includes (step a) discharging the ink composition onto a support, and (step b) irradiating the ink composition with active energy rays at an oxygen partial pressure of 0.1 atm or less to cure the ink composition.

In the inkjet recording method of the present invention, an image is formed by the ink composition cured on the recording medium by including the (step a) and (step b).

Further, the inkjet recording method of the present invention may be carried out in a multi-pass mode, in which the (step a) and (step b) are carried out twice or more in the same portions on the recording medium, that is, printing may be carried out by overstriking the same portions. In a case of carrying out the printing in a multi-pass mode by using the ink composition of the present invention, an image having excellent glossiness is obtained.

Furthermore, the printed material of the present invention is a printed material recorded according to the inkjet recording method of the present invention.

The support preferably has a film thickness from 10 µm to 90 µm, and more preferably a film thickness from 20 µm to 80 µm. Further, the support is preferably a resin film containing at least one component selected from the group consisting of polyethylene terephthalate, polyethylene, polypropylene, and nylon.

Furthermore, the ink composition of the present invention is suitable for package printing, in particular, package printing for food packaging.

In the (step a) in the inkjet recording method of the present invention, the inkjet recording device which will be described in detail may be used.

### <Inkjet Recording Device>

The inkjet recording device that can be used in the inkjet recording method of the present invention is not particularly limited, and one which is arbitrarily selected from known inkjet recording devices capable of achieving a desired resolution can be used. That is, any known inkjet recording devices including commercially available products can be used to carry out the discharge of the ink composition onto the support in the (step a) of the inkjet recording method of the present invention.

Examples of the inkjet recording device that can be used in the present invention include devices including, for example, an ink supply system, a temperature sensor, and a source of active energy rays.

The ink supply system includes, for example, a main tank containing the ink composition of the present invention, a supply pipe, an ink supply tank immediately before an inkjet head, a filter, and a piezo inkjet head. The piezo inkjet head may be driven so as to discharge multisize dots of preferably 1 pl to 100 pl, and more preferably 8 pl to 30 pl, at a resolution of preferably 320 dpi x 320 dpi to 4,000 dpi x 4,000 dpi, more preferably 400 dpi x 400 dpi to 1,600 dpi x 1,600 dpi, and still more preferably 720 dpi x 720 dpi. In addition, dpi as mentioned in the present invention denotes the number of dots per 2.54 cm.

As described above, in the ink composition of the present invention, since it is preferable for the ink composition discharged to be at a constant temperature, the inkjet recording device is preferably equipped with a means for stabilizing an ink composition temperature. The sections to be controlled at a constant temperature include all of the member of piping system and components ranging from an ink tank (an intermediate tank in a case where an intermediate tank is present) to a nozzle injection face. That is, a section from the ink supply tank to the inkjet head is thermally insulated and heated.

A method of controlling temperature is not particularly limited, but it is preferable to provide, for example, a plurality of temperature sensors at pipe section positions, and control heating according to the ink flow rate of the ink composition and the temperature of the environment. The temperature sensors may be provided on the ink supply tank and in the vicinity of the inkjet head nozzle. Further, the head unit that is to be heated is preferably thermally shielded or insulated so that the device main body is not influenced by the temperature of the outside air. In order to reduce the printer start-up time required for heating or in order to reduce the thermal energy loss, it is preferable to thermally insulate the head unit from other sections and also to reduce the heat capacity of the entire heating unit.

The active energy ray-curable ink composition such as the ink composition of the present invention generally has a viscosity that is higher than that of an aqueous ink composition used as an ordinary ink composition for inkjet recording, and thus, viscosity variation due to a change in temperature at the time of discharge is large. The viscosity variation in the ink composition has a large effect on changes in liquid droplet size and changes in liquid droplet discharge speed, and as a result, causes the image quality to be degraded. It is therefore necessary to maintain the temperature of the ink composition at the time of discharge as constant as possible. In the present invention, the control range for the temperature of the ink composition is preferably ±5°C of a set temperature, more preferably ±2°C of the set temperature, and still more preferably ±1°C of the set temperature.

Next, the (step b) will be described.

The ink composition discharged onto the recording medium is cured by the irradiation of active energy rays. This is due to a polymerization initiating species such as radicals, which are generated by decomposition of the polymerization initiator included in the ink composition of the present invention by the irradiation of active energy rays, the initiating species functioning so as to make a polymerization reaction of a polymerizable compound take place and to promote it. At this time, if a sensitizer is present together with the polymerization initiator in the ink composition, the sensitizer in the system absorbs active energy rays, becomes excited, and promotes decomposition of the polymerization initiator by contact with the polymerization initiator, thus being able to acquire curing reaction with higher sensitivity.

Furthermore, the polymerization initiator used in the ink composition of the present invention has sufficient sensitivity for low-output active energy rays. Therefore, curing is suitably carried out so that the illumination intensity on the exposed surface is preferably from 10 mW/cm² to 4,000 mW/cm², and more preferably from 20 mW/cm² to 2,500 mW/cm².

As a main source of active energy rays, a mercury lamp, a gas laser, a solid laser, or the like is used, and as a light source used for curing an ultraviolet ray-curable ink composition for inkjet recording, a mercury lamp and a metal halide lamp are widely known. In the present invention, these active energy sources may be used. However, from the viewpoint of protection of the environment, there has recently been a strong demand for mercury free products, and replacement by a GaN-based semiconductor ultraviolet light-emitting device is very useful from industrial and environmental viewpoints. Furthermore, LED (UV-LED) and LD (UV-LD) have small dimensions, long life, high efficiency, and low cost, and can be preferably used as a photocurable inkjet light source.

Furthermore, light-emitting diodes (LED) and laser diodes (LD) can be used as the source of active energy rays. In particular, when a source of ultraviolet rays is needed, an ultraviolet LED or an ultraviolet LD may be used. For example, Nichia Corporation has marketed a violet LED having a wavelength of the main emission spectrum of between 365 nm and 420 nm. Furthermore, when a shorter wavelength is needed, US6084250A discloses an LED that can emit active energy rays whose wavelength is centered between 300 nm and 370 nm. Furthermore, other ultraviolet LEDs are available and active rays having a wavelength in a different ultraviolet ray bandwidth may be irradiated. The source of active energy rays particularly preferably in the present invention is a UV-LED, and a UV-LED having a peak wavelength at 340 nm to 400 nm is particularly preferred.

In addition, the maximum illumination intensity of the LED on a recording medium is preferably from 10 mW/cm² to 2,000 mW/cm², more preferably 20 mW/cm² to 1,000 mW/cm², and particularly preferably 50 mW/cm² to 800 mW/cm².

The ink composition of the present invention is suitably irradiated with such active energy rays for preferably 0.01 seconds to 120 seconds, and more preferably 0.1 seconds to 90 seconds.

Irradiation conditions and a basic irradiation method for active energy rays are disclosed in JP1985-132767A (JP-S60-132767A). Specifically, a light source is provided on either side of a head unit that includes a discharge device for an ink composition, and the head unit and the light source are made to scan by a so-called shuttle system. Irradiation of active energy rays is carried out after a certain time (preferably 0.01 seconds to 0.5 seconds, more preferably 0.01 seconds to 0.3 seconds, and still more preferably 0.01 seconds to 0.15 seconds) has elapsed from when the ink composition has landed. By controlling the time from landing of the ink composition to irradiation so as to be a minimum in this way, it becomes possible to prevent the ink composition that has landed on a recording medium from blurring before being cured. Furthermore, since the ink composition can be exposed before it reaches a deep area of a porous recording medium that the light source cannot reach, it is possible to prevent monomers from remaining unreacted, which is therefore preferable.

In addition, curing may be completed using another light source that is not driven. Further, examples of the irradiation method include a method employing an optical fiber and a method in which a collimated light (UV light) is irradiated on a mirror surface provided on a head unit side face, and a recorded area is irradiated with the reflected light. Such a curing method may also be applied to the inkjet recording method of the present invention.

Further, when active energy rays are irradiated in the present invention, poor oxygen atmosphere is generated as an atmosphere in the neighborhood of the surface of the recording medium. It is known that it is possible to reduce the energy of the active energy rays required for curing by reducing the oxygen concentration in the curing atmosphere, but in the present invention, it has been found that such reduction of the oxygen concentration is effective for the improvement of the migration, odor, or shrinkage, that is important as the characteristics of a package printed material.

With the ink composition for radical polymerization, the surface in contact with air is particularly susceptible to inhibition of oxygen polymerization, and poor curing of the surface tends to occur. Due to deteriorated curability of the surface, the monomers remain in the film or a crosslinked structure of the film is formed with polyfunctional monomers, and thus, the performance of keeping the low-molecular components remaining in the film becomes insufficient, leading to remarkable deterioration in migration or odor. However, it is presumed that when exposed to an environment having a low oxygen concentration, the degree of inhibition of oxygen polymerization is reduced, leading to improvement in migration or odor.

In addition, since only the surface of the cured film is selectively subjected to inhibition of oxygen polymerization, and as a result, a difference in the curability from the inside of the film providing good curability is generated, resulting in a distribution in volumetric shrinkages. Thus, shrinkage easily occurs in a thin support for packaging. As for this, it is presumed that when exposed to an environment having a low oxygen concentration, the volumetric shrinkage of the inside and the surface of the film becomes uniform, thereby improving the shrinkage uniformity.

In the present invention, it is preferable to carry out irradiation of active energy rays under a poor oxygen atmosphere having an oxygen partial pressure of 0.1 atm or less.

Usually, the oxygen partial pressure is 0.21 atm (atmospheric pressure) (1 atm) under atmospheric air, and therefore, in order to accomplish reduction of an oxygen partial pressure to 0.1 atm or less, (a) the atmospheric pressure during the exposure can be lowered to 0.47 atm or less, or (b) air and a gas other than oxygen (for example, inert gas such as nitrogen and argon) can be mixed to 53% by volume or more with respect to air.

The poor oxygen atmosphere in the present invention is not particularly limited, but any one of the methods above may be used.

The oxygen partial pressure is preferably 0.10 atm or less, more preferably 0.08 atm or less, and particularly preferably 0.05 atm or less.

The lower limit in the oxygen partial pressure is not particularly limited. By substituting vacuum or atmosphere with a gas other than air (for example nitrogen), the oxygen partial pressure can be practically adjusted to 0 atm, which is also a preferable method.

The oxygen concentration by inert gas substitution is preferably controlled to 0.01 % by volume to 10% by volume (at this time, the oxygen partial pressure is controlled to 0.0001 atm to 0.10 atm), and more preferably to 0.1% by volume to 5% by volume.

Examples of the means for controlling the oxygen concentration under a curing atmosphere of the 0.01% to 10% include a method in which a nitrogen atmosphere or a carbon dioxide atmosphere is used with an image forming device as a close system. Examples of the nitrogen supply means include a method using a nitrogen bomb and a method using a device for separating only a nitrogen gas from the air, based on the difference in the permeability to a hollow fiber membrane between nitrogen and oxygen. A supply method with a bomb as a \carbon dioxide supply means is included.

The inert gas refers to general gases such as N₂, H₂, and CO₂, and rare gases such as He, Ne, and Ar. Among these, from the viewpoints of safety or easy availability, and cost, N₂ is suitably used.

The "under reduced pressure" refers to a state at 500 hPa (0.05 MPa) or less, and preferably 100 hPa (0.01 MPa) or less.

The ink-jet recording device which is particularly suitable for use in the present invention will be described in more detail. The inkjet recording method of the present invention described above is preferably carried out by the inkjet recording device of the present invention which will be described below.

The inkjet recording device of the present invention has a transporting means for transporting a recording medium, an energy providing means for providing active energy to a liquid provided on the recording medium, a means for using the atmosphere while providing energy by the energy providing means as a poor oxygen atmosphere, and a control means for controlling the transporting means and the energy providing means while discharging a liquid from the liquid providing unit, in which a plurality of line-type droplet ejecting heads corresponding to the entire recordable width of the recording medium are arranged, and a droplet ejecting head for discharging the ink composition and the energy providing means are preferably sequentially arranged from the upstream side in the transporting direction of the recording medium.

The inkjet recording device of the present invention is an inkjet recording device in a so-called single-pass system, in which a droplet ejecting head for discharging a treatment liquid, a droplet ejecting head for discharging an ink composition, and an energy providing means are preferably sequentially arranged from the upstream side in the transporting direction of the recording medium. Such arrangement makes it possible to keep the surface of the droplet-ejected treatment liquid in the liquid form while providing the treatment liquid and then droplet-ejecting the ink composition. Further, by using a poor oxygen atmosphere at a time of exposing and curing, polymerization inhibition of a polymerizable compound or the like is inhibited, whereby promoting a curing reaction, and further improving drawing properties of fine areas such as thin lines.

Fig. 1 is a schematic view of the inkjet recording device which is preferably used in the present invention. A support 6 stretched to support-winding rolls 5 and 5', which are transporting means of the support, is transported in the arrow direction, and the ink compositions in the respective colors (K: black, Y: yellow, M: magenta, C: cyan, and W: white) are discharged from an inkjet head unit 7, in which a droplet ejecting head for discharging the ink composition of the respective colors (K: Black, Y: Yellow, M: magenta, C: cyan, and W: white) is arranged.

As shown in Fig. 1, an LED light source unit 1 is surrounded by an inert gas blanket 2 and is connected to an inert gas generating device 4 via an inert gas pipe 3. The inert gas generating device 4 which is a means for using a poor oxygen atmosphere as the atmosphere in the inert gas blanket 2 supplies an inert gas into the inert gas blanket 2 via the inert gas pipe 3. Thus, in the initial state, the atmosphere in the inert gas blanket 2 is air, but when the inert gas generating device 4 is operated, the air in the inert gas blanket 2 is replaced with an inert gas. As described above, N₂ may be used as the inert gas.

In the present invention, the support has a film thickness from 10 µm to 90 µm, and further, as the support, a resin film containing at least one component selected from the group consisting of polyethylene terephthalate, polyethylene, polypropylene, and nylon is preferably used.

Further, the "resin film containing at least one component" as described above means one having at least one layer containing the components selected from the group consisting of polyethylene terephthalate, polyethylene, polypropylene, and nylon, in the case where the resin film is a laminated film having a multilayer structure. Further, as in a laminate film with polypropylene and polyethylene, the resin film may have two or more layers containing components selected from the group consisting of polyethylene terephthalate, polyethylene, polypropylene, and nylon.

As the polyethylene, LDPE (low-density polyethylene), MDPE (meidum-density polyethylene), or HDPE (high-density polyethylene) is preferably used; as the polypropylene, CPP (cast polypropylene), OPP (biaxially oriented polypropylene), KOP (polyvinylidene chloride-coated OPP), or AOP (PVA-coated OPP) is preferably used; as the PET, biaxially oriented polyester is preferably used; and as the nylon, ON (oriented nylon), KON (oriented nylon), or CN (cast nylon) is preferably used.

In addition, a combination of EVA (ethylene/vinyl acetate copolymerization film), PVA (Vinylone), EVOH (polyvinyl alcohol), PVC (polyvinyl chloride), PVDC (polyvinylidene chloride, Saran), Cellophane (PT, MST, and K Cello), ZX (Zekuron (polyacrylonitrile, PAN)), and PS (polystyrene and styryl) is preferably used.

According to the applications of the package, optimal materials are selected, and a film in a multilayer structure may be made so as to prepare a film having a combination of the characteristics of the respective materials.

In addition, for the purpose of improvement of the strength of the package, oxygen blocking, or the like, AL (aluminum foil), a VM film (aluminum-deposited film, a transparent deposited film), or the like can also be incorporated in the multiplayer surface.

Furthermore, in the inkjet recording method of the present invention, the inkjet ink composition of the present invention is subjected to inkjet printing on the support and then the upper part of the printed material is preferably subjected to laminate processing.

By the laminate processing, elution of the ink component from the printed material, blocking, and odor can be inhibited, and the inkjet ink composition can be preferably used, in particular, for food package.

In addition, recently, a co-extruded film formed by extruding the resins together from two or more parallel slits and performing film formation and lamination at once is also preferably used. Lamination can be carried out to make at most 5 to 7 layers even a thin layer in several µm that cannot be used to make a film form, and therefore, films that can be used in various performance and applications are made.

In the inkjet recording method of the present invention, a support having a film thickness of 10 µm to 90 µm is preferably used, and a support having a film thickness of 20 µm to 80 µm is more preferably used.

By employing such inkjet recording method as described above, it is possible to maintain a uniform dot diameter of landed ink composition even for various types of recording medium having different levels of surface wettability, thereby improving the image quality. In order to obtain a color image, it is preferable to superimpose colors in order from those with a low lightness. By superimposing ink compositions in order from one with low lightness, it is easy for irradiated active energy rays to reach ink compositions of the lower part of an image, the good curing sensitivity, a decreased amount of residual monomers, and an improvement in adhesion can be expected. Furthermore, although it is possible to discharge all colors and then expose them at the same time for the irradiation, it is preferable to expose one color at a time from the viewpoint of promoting curing.

In this way, the ink composition of the present invention may be cured by irradiation with active energy rays in high sensitivity to form an image on the surface of the recording medium.

The ink composition of the present invention is preferably used in an ink set including plural inkjet recording inks.

In the inkjet recording method of the present invention, the order in which colored ink compositions are discharged is not particularly limited, but it is preferable to apply to a recording medium from a colored ink composition having a high lightness; in the case where yellow, cyan, magenta, and black ink compositions are used, they are preferably applied on the recording medium in the order of yellow, cyan, magenta, black. Furthermore, when a white ink composition is additionally used, they are preferably applied on the recording medium in the order of white, yellow, cyan, magenta, black. Moreover, the present invention is not limited thereto, and an ink set of the present invention including a total of seven colors, that is, yellow light cyan, light magenta, cyan, magenta, black, and white ink compositions may preferably be used, and in this case, they are preferably applied on the recording medium in the order of white, light cyan, light magenta, yellow, cyan, magenta, black.

### [Examples]

Examples and Comparative Examples are shown below, and will be described the present invention more specifically. However, the present invention is not limited to these Examples.

Further, "part(s)" in the following description represent(s) "part(s) by mass" unless otherwise specified.

The components used in the present invention are as follows.

### <Colorant>

- IRGALITE BLUE GLVO (cyan pigment, manufactured by BASF Japan, Ltd.)
- CINQUASIA MAGENTA RT-355-D (magenta pigment, manufactured by BASF Japan, Ltd.)
- NOVOPERM YELLOW H2G (yellow pigment, manufactured by Clariant (Japan) K. K.)
- SPECIAL BLACK 250 (black pigment, manufactured by BASF Japan, Ltd.)
- TIPAQUE CR60-2 (white pigment, manufactured by Ishihara Sangyo Kaisha, Ltd.)

### <Dispersant>

· SOLSPERSE 32000 (dispersant manufactured by Lubrizol)

### <(Component A) Polymerizable Compound>

- SR9003 (PO modified neopentyl glycol diacrylate, manufactured by Sartomer)
- 3-Methyl-1,5-pentanedioldiacrylate (SR341, manufactured by Sartomer)
- TMPTA (trimethylolpropane triacrylate, SR350, manufactured by Sartomer)
- 1,10-Decanedioldiacrylate (CD595, manufactured by Sartomer)

### <(Component B) Polymerization Initiator>

- IRGACURE 819 (bis(2,4,6-trimethylbenzoyl)phenylphosphine oxide, manufactured by BASF, molecular weight 419)
- IRGACURE 379 (2-dimethylamino-2-(4-methylbenzyl)-1-(4-morpholin-4-yl-phenyl)butan-1-one, manufactured by BASF, molecular weight 380)
- Speedcure 7010 (Compound I-B described above, manufactured by Lambson, molecular weight 1,899)
- Omnipol BP (Compound I-F described above, manufactured by Rahn AG, molecular weight 960)
- Speedcure ITX (isopropylthioxanthone, manufactured by LAMBSON, molecular weight 254)

### <(Component C) Vegetable Oil>

- Linseed oil (amount of saturated fatty acids: 8.9% by mass, iodine value: 168 to 190, manufactured by Wako Pure Chemical Industries, Ltd.)
- Soybean oil (amount of saturated fatty acids: 15.65% by mass, iodine value: 114 to 138, manufactured by Wako Pure Chemical Industries, Ltd.)
- Corn oil (amount of saturated fatty acids: 12.9% by mass, iodine value: 103 to 130, manufactured by Wako Pure Chemical Industries, Ltd.)
- Cottonseed oil (amount of saturated fatty acids: 25.9% by mass, iodine value: 102 to 120, manufactured by Wako Pure Chemical Industries, Ltd.)
- Peanut oil (amount of saturated fatty acids: 21.7% by mass, iodine value: 100 or less, manufactured by Yoneyama Yakuhin Kogyo Co., Ltd.)

### <Polymerization Inhibitor>

· UV-12 (FLORSTAB UV12, nitroso-based polymerization inhibitor, tris(N-nitroso-N-phenylhydroxylamine)aluminum salt, manufactured by Kromachem)

### <Surfactant>

· BYK 307 (silicone-based surfactant, manufactured by BYK Chemie)

### <Other Compounds>

- Dodecanol (manufactured by Wako Pure Chemical Industries, Ltd.)
- Dimethyl phthalate (manufactured by Wako Pure Chemical Industries, Ltd.)

### (Preparation of Each Mill Base)

### <Preparation of Cyan Mill Base A>

300 parts by mass of IRGALITE BLUE GLVO, 620 parts by mass of SR9003, and 80 parts by mass of SOLSPERSE 32000 were mixed under stirring to obtain a cyan mill base A. Further, preparation of the cyan mill base A was carried out by dispersing using a Motor Mill M50 disperser (manufactured by Eiger Machinery, Inc.) with zirconia beads having a diameter of 0.65 mm at a circumferential speed of 9 m/s for 4 hours.

### <Preparation of Magenta Mill Base B, Yellow Mill Base C, Black Mill Base D, and White Mill Base E>

In the same manner as the cyan mill base A, a magenta mill base B, a yellow mill base C, a black mill base D, and a white mill base E were prepared using the composition and the dispersion conditions shown in Table 1.

**[Table 1]**

| Mill base | | Cyan mill base A | Magenta mill base B | Yellow mill base C | Black mill base D | White mill base E |
|---|---|---|---|---|---|---|
| Composition (parts) | IRGALITE BLUE GLVO | 300 | - | - | - | - |
| | CINQUASIA MAGENTA RT-355-D | - | 300 | - | - | - |
| | NOVOPERM YELLOW H2G | - | - | 300 | - | - |
| | SPECIAL BLACK 250 | - | - | - | 400 | - |
| | TIPAQUE CR60-2 | - | - | - | - | 500 |
| | SR9003 | 620 | 600 | 600 | 520 | 440 |
| | SOLSPERSE 32000 | 80 | 100 | 100 | 80 | 60 |
| Dispersion condition | Circumferential speed (m/s) | 9 | 9 | 9 | 9 | 9 |
| | Time (hours) | 4 | 10 | 10 | 7 | 4 |

(Examples 1 to 19 and Comparative Examples 1 to 4)

### <Method for Preparing Ink Composition>

The components listed in Table 2 were mixed in the amounts (parts by mass) described in the Table, and stirred to obtain each of ink compositions. Further, "-" in the Table means that the corresponding components are not added.

### <Inkjet Recording Method>

In the inkjet recording device shown in Fig. 1, as an inkjet head, four CA3 heads in each color manufactured by TOSHIBA TEC Corp. were arranged in parallel and the inkjet heads were warmed to 45°C, and the frequency was controlled so as to draw in a droplet ejecting size of 42 pL.

As a light source, an LED light source unit (LED Zero Solidcure, manufactured by Integration Technology) having a peak wavelength of 385 nm is arranged in an inert gas blanket.

As an inert gas source, a N₂ gas generating device Maxi-Flow 30 (manufactured by Inhouse Gas) equipped with a compressor was connected at a pressure of 0.2 MPa·s to adjust the N₂ concentration in the blanket to a range of 90% to 99%, and N₂ was allowed to flow thereinto at a flow rate of 2 L/min to 10 L/min to set the N₂ concentration and the O₂ concentration to the concentrations described in Table 2.

As the support, a Pylen film - OTP3162 (A4 size, polypropylene sheet, film thickness of 40 µm, manufactured by TOYOBO Co., Ltd.) was used to scan the support at a speed of 30 m/min to draw a 100% solid image, thereby obtaining a printed material. The following performance of the obtained printed material was evaluated.

### <Evaluation of Flexibility>

In accordance with the inkjet recording method, a solid image having an average film thickness of the image area of 12 µm was drawn to obtain a printed material.

Thereafter, the printed material was grabbed in the state of the thumbs of both hands are 1 cm apart from each other, and rubbed once per second. Based on the number of times that the image started to peel after rubbing, the flexibility was evaluated.
1: The image is peeled after rubbing once.
2: The image is peeled after rubbing 2 to 4 times.
3: The image is peeled after rubbing 5 to 7 times.
4: The image is peeled after rubbing 8 or 9 times.
5: The image is not peeled even after rubbing 10 times.

### <Evaluation of Odor>

The image of the printed material obtained by the inkjet recording method was enclosed in a plastic envelope having a zipper in 30 cm x 30 cm, and left to stand for 24 hours.

Thereafter, the zipper was released and the odor was evaluated. For the evaluation, an average of ten persons was employed. Further, the values shall be rounded off to the decimal point of the average value.
1: There is a very strong odor.
2: There is a strong odor.
3: There is a certain degree of odor, but it is not at an uncomfortable level.
4: There is a slight odor, but it is negligible.
5: There is almost no odor.

### <Evaluation of Tape Release Properties (Adhesion to Support)>

In accordance with the inkjet recording method, a solid image having an average film thickness of the image area of 12 µm was drawn to obtain a printed material.

Thereafter, a cellophane tape (manufactured by Nichiban Co., Ltd.) was adhered to each of the printed materials, and the tape release properties were evaluated according to the degree of the printed material peeling.
1: The image was completely peeled.
2: Most of the image was peeled.
3: The image was partly peeled.
4: The peeling of image was not observed.

### <Evaluation of Dischargeability (Inkjet Dischargeability)>

The obtained ink composition was charged into an inkjet recording device (manufactured by Fujifilm Corporation, Luxel Jet UV350GTW), and then the presence or absence of the missing of the dots and the scattering of the ink of a printed material obtained after continuous printing at normal temperature (25°C) for 1 hour was observed and the average value of the results obtained from the observation carried out three times was evaluated by the following criteria.
1: There were 6 or more occurrences on average of the missing of the dots and the scattering of the ink.
2: There were 2 or more and less than 6 occurrences on average of the missing of the dots and the scattering of the ink.
3: There were 1 or more and less than 2 occurrences on average of the missing of the dots and the scattering of the ink.
4: There was less than 1 occurrence on average of the missing of the dots and the scattering of the ink.

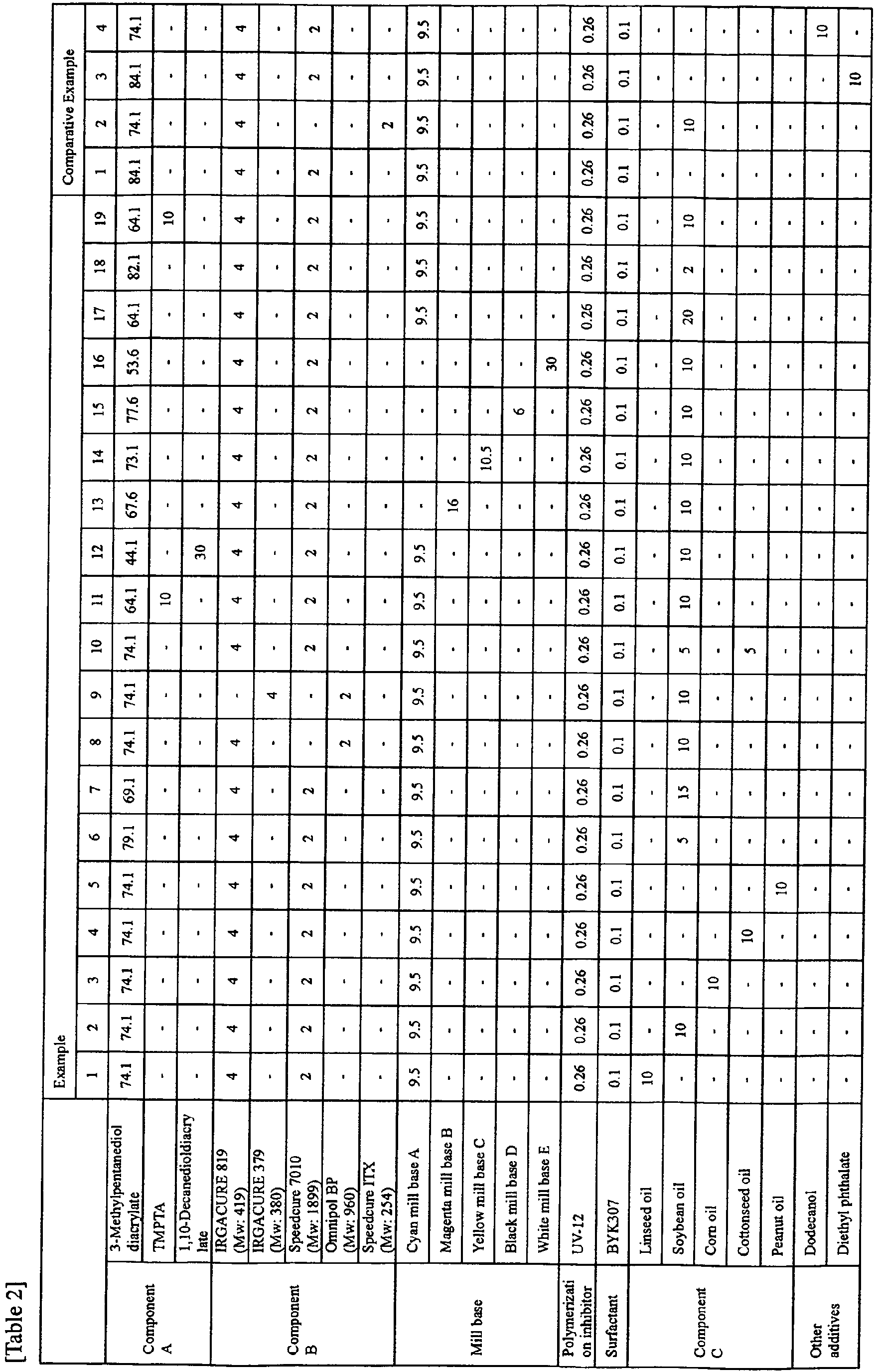

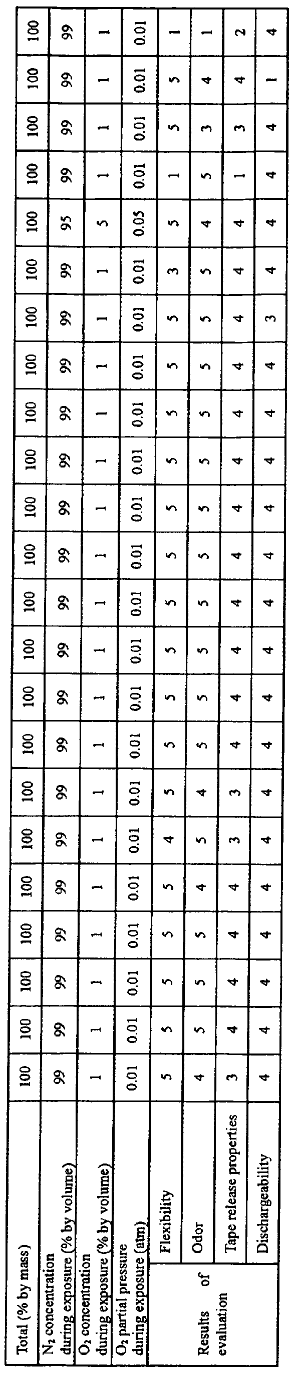

As shown in Table 2, the inkjet ink compositions of Examples 1 to 19 were all ink compositions, from which printed materials having excellent inkjet dischargeability, flexibility of the obtained image, and adhesion to a support, or reduced odor can be obtained.

On the other hand, the inkjet ink composition of Comparative Example 1, which did not include (Component C) a vegetable oil, had poor flexibility of the obtained image and adhesion to a support.

The inkjet ink composition of Comparative Example 2, which did not include the compound represented by the formula (1) or (2), had inferior odor inhibition of the printed material to those of Examples 1 to 19.

The inkjet ink composition of Comparative Example 3, which included diethyl phthalate instead of (Component C) vegetable oil, had poor inkjet dischargeability.

In addition, the inkjet ink composition of Comparative Example 4, which included dodecanol instead of (Component C) vegetable oil, had poor flexibility of the obtained image and adhesion to a support, and further, a strong odor of the printed material.

## Claims

1. An inkjet ink composition comprising:
(Component A) a polymerizable compound;
(Component B) a polymerization initiator; and
(Component C) a vegetable oil selected from olive oil, cacao oil, kapok oil, mustard oil, apricot kernel oil, sesame oil, radish seed oil, soybean oil, chaulmoogra oil, camellia oil, corn oil, rapeseed oil, niger oil, rice bran oil, palm oil, grape seed oil, almond oil, cottonseed oil, coconut oil, and peanut oil,
wherein the component B contains a compound represented by the following formula (1) or (2): 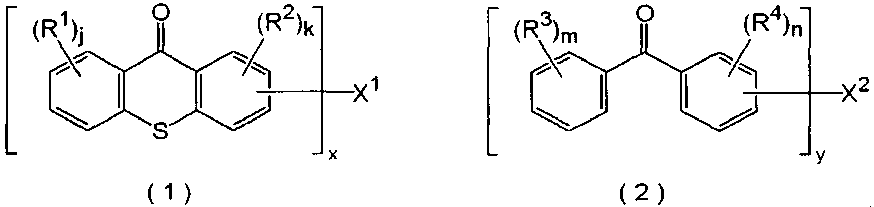 wherein R¹, R², R³ and R⁴ each independently represent an alkyl group having 1 to 5 carbon atoms, or a halogen atom; x and y each independently represent an integer of 2 to 4; j and m each independently represent an integer of 0 to 4; k and n each independently represent an integer of 0 to 3, when j, k, m, and n are an integer of 2 or more, a plurality of R¹'s, R²'s, R³'s, and R⁴'s may be the same as or different from each other; X¹ represents an x-valent linking group containing at least any one selected from a hydrocarbon chain, an ether bond, and an ester bond; and X² represents a y-valent linking group containing at least any one selected from a hydrocarbon chain, an ether bond, and an ester bond.

2. An inkjet ink composition according to Claim 1, wherein the component A contains a polyfunctional (meth)acrylate compound.

3. An inkjet ink composition according to Claim 2, wherein the content of the polyfunctional (meth)acrylate compound is 60% by mass or more with respect to the total amount of the inkjet ink composition.

4. The inkjet ink composition according to any preceding claim, wherein the component C is a vegetable oil containing 10% by mass or more of saturated fatty acids based on the total amount of fatty acids included in the component (C).

5. An inkjet ink composition according to any preceding claim, wherein the iodine value of the component C is 140 or less.

6. An inkjet ink composition according to any preceding claim, wherein the content of the component C is 3% by mass to 15% by mass with respect to the total amount of the inkjet ink composition.

7. An inkjet ink composition according to any preceding claim, wherein the content of the compound represented by the formula (1) or (2) is 0.01% by mass to 10% by mass with respect to the total amount of the inkjet ink composition.

8. An inkjet ink composition according to any preceding claim, wherein the component B further contains a bisacylphosphine compound having a molecular weight of 340 or more.

9. An inkjet ink composition according to any preceding claim, which does not comprise a polymerization initiator having a molecular weight of less than 340 as the component B, or the content of the polymerization initiator having a molecular weight of less than 340 is 1% by mass or less with respect to the total amount of the inkjet ink composition.

10. Use of an inkjet ink composition according to any preceding claim, for package printing.

11. An inkjet recording method comprising:
discharging an inkjet ink composition as defined in any of Claims 1-9 onto a support; and
subsequently irradiating the inkjet ink composition with active energy rays under an atmosphere of an oxygen partial pressure of 0.1 atm or less to cure the inkjet ink composition.

12. An inkjet recording method according to Claim 11, wherein the support is a resin film having a film thickness from 10 µm to 90 µm and containing at least one component selected from polyethylene terephthalate, polyethylene, polypropylene and nylon.

13. The inkjet recording method according to Claim 11 or Claim 12, wherein the active energy rays are active energy rays irradiated from an LED.

14. Printed material obtained by the inkjet recording method as defined in any of Claims 11-13.

## Patentansprüche

1. Tintenstrahl-Tintenzusammensetzung, umfassend:
(Komponente A) eine polymerisierbare Verbindung;
(Komponente B) einen Polymerisationsinitiator; und
(Komponente C) ein Pflanzenöl, ausgewählt aus Olivenöl, Kakaoöl, Kapoköl, Senföl, Aprikosenkernöl, Sesamöl, Rettichsamenöl, Sojaöl, Chaulmoograöl, Kamellienöl, Maisöl, Rapsöl, Nigersaatöl, Reiskleieöl, Palmöl, Traubenkernöl, Mandelöl, Baumwollöl, Kokosöl und Erdnussöl,
worin die Komponente B eine durch die folgende Formel (1) oder (2) dargestellte Verbindung umfasst: 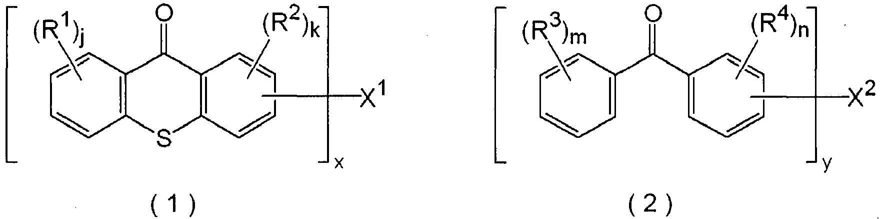 worin R¹, R², R³ und R⁴ jeweils unabhängig eine Alkylgruppe mit 1 bis 5 Kohlenstoffatomen oder ein Halogenatom darstellen; x und y jeweils unabhängig eine ganze Zahl von 2 bis 4 darstellen; j und m jeweils unabhängig voneinander eine ganze Zahl von 0 bis 4 darstellen; k und n jeweils unabhängig eine ganze Zahl von 0 bis 3 darstellen, wenn j, k, m und n eine ganze Zahl von 2 oder größer darstellen, die mehreren R¹, R², R³ und R⁴ gleich oder verschieden sein können; X¹ eine x-valente Verknüpfungsgruppe darstellt, die zumindest irgendeines umfasst, das ausgewählt ist einer Kohlenwasserstoffkette, einer Etherbindung und einer Esterbindung; und X² eine y-valente Verknüpfungsgruppe darstellt, die zumindest irgendeines umfasst, das ausgewählt ist aus einer Kohlenwasserstoffkette, einer Etherbindung und einer Esterbindung.

2. Tintenstrahl-Tintenzusammensetzung gemäß Anspruch 1, worin die Komponente (A) eine polyfunktionelle (Meth)acrylatverbindung umfasst.

3. Tintenstrahl-Tintenzusammensetzung gemäß Anspruch 2, worin der Gehalt der polyfunktionellen (Meth)acrylatverbindung 60 Masse% oder mehr beträgt, bezogen auf die Gesamtmenge der Tintenstrahl-Tintenzusammensetzung.

4. Tintenstrahl-Tintenzusammensetzung gemäß irgendeinem vorhergehenden Anspruch, worin die Komponente (C) ein Pflanzenöl ist, das 10 Masse% oder mehr an gesättigten Fettsäuren enthält, bezogen auf die Gesamtmenge der Fettsäuren, die in der Komponente (C) enthalten sind.

5. Tintenstrahl-Tintenzusammensetzung gemäß irgendeinem vorhergehenden Anspruch, worin der Jodwert der Komponente (C) 140 oder weniger beträgt.

6. Tintenstrahl-Tintenzusammensetzung gemäß irgendeinem vorhergehenden Anspruch, worin der Mengenanteil der Komponente (C) 3 Masse% bis 15 Masse% beträgt, bezogen auf die Gesamtmenge der Tintenstrahl-Tintenzusammensetzung.

7. Tintenstrahl-Tintenzusammensetzung gemäß irgendeinem vorhergehenden Anspruch, worin der Mengenanteil der durch die Formel (1) oder (2) dargestellten Verbindung 0,01 Masse% bis 10 Masse% beträgt, bezogen auf die Gesamtmenge der Tintenstrahl-Tintenzusammensetzung.

8. Tintenstrahl-Tintenzusammensetzung gemäß irgendeinem vorhergehenden Anspruch, worin die Komponente (B) ferner eine Bisacylphosphinverbindung mit einem Molekulargewicht von 340 oder größer enthält.

9. Tintenstrahl-Tintenzusammensetzung gemäß irgendeinem vorhergehenden Anspruch, die keinen Polymerisationsinitiator mit einem Molekulargewicht von weniger als 340 als Komponente (B) enthält, oder worin der Mengenanteil des Polymerisationsinitiators mit einem Molekulargewicht von weniger als 340 1 Masse% oder weniger beträgt, bezogen auf die Gesamtmenge der Tintenstrahl-Tintenzusammensetzung.

10. Verwendung der Tintenstrahl-Tintenzusammensetzung gemäß irgendeinem vorhergehenden Anspruch für den Verpackungsdruck.

11. Tintenstrahl-Aufzeichnungsverfahren, umfassend:
Ausstoßen einer wie in irgendeinem der Ansprüche 1 bis 9 definierten Tintenstrahl-Tintenzusammensetzung auf einen Träger; und
anschließend Bestrahlen der Tintenstrahl-Tintenzusammensetzung mit aktiven Energiestrahlen unter einer Atmosphäre mit einem Sauerstoff-Partialdruck von 0,1 Atm oder weniger, um die Tintenstrahl-Tintenzusammensetzung zu härten.

12. Tintenstrahl-Aufzeichnungsverfahren gemäß Anspruch 11, worin der Träger eine Harzfolie mit einer Foliendicke von 10 µm bis 90 µm ist und mindestens eine Komponente enthält, die ausgewählt ist aus Polyethylenterephthalat, Polyethylen, Polypropylen und Nylon.

13. Tintenstrahl-Aufzeichnungsverfahren gemäß Anspruch 11 oder 12, worin die aktiven Energiestrahlen aktive Energiestrahlen sind, die von einer LED ausgestrahlt werden.

14. Bedrucktes Material/Drucksache, erhalten durch das Tintenstrahl-Aufzeichnungsverfahren, wie es in irgendeinem der Ansprüche 11 bis 13 definiert ist.

## Revendications

1. Composition d'encre pour jet d'encre comprenant :
(Composant A) un composé polymérisable ;
(Composant B) un initiateur de polymérisation ; et
(Composant C) une huile végétale sélectionnée parmi de l'huile d'olive, de l'huile de cacao, de l'huile de kapok, de l'huile de moutarde, de l'huile de noyau d'abricot, de l'huile de sésame, de l'huile de graines de radis, de l'huile de soja, de l'huile de chaulmoogra, de l'huile de camélia, de l'huile de maïs, de l'huile de colza, de l'huile de Niger, de l'huile de riz, de l'huile de palme, de l'huile de pépins de raison, de l'huile d'amande, de l'huile de coton, de l'huile de noix de coco et de l'huile d'arachide, dans laquelle le composant B contient un composé représenté par la formule (1) ou (2) suivante : 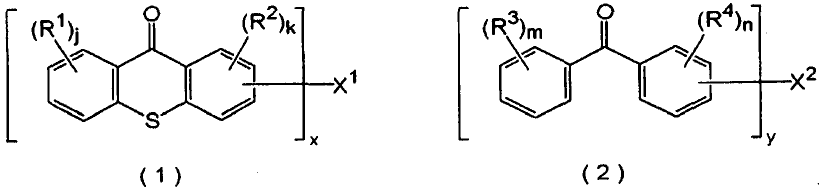 dans lesquelles R¹, R², R³ et R⁴ représentent chacun indépendamment un groupe alkyle ayant de 1 à 5 atomes de carbone, ou un atome d'halogène ; x et y représentent chacun indépendamment un entier de 2 à 4 ; j et m représentent chacun indépendamment un entier de 0 à 4 ; k et n représentent chacun indépendamment un entier de 0 à 3, quand j, k, m et n sont un entier de 2 ou plus, une pluralité de R¹' s, R²'s, R³' s et R⁴'s peuvent être identiques ou différents les uns des autres ; X¹ représente un groupe de liaison de valence x contenant au moins l'une quelconque sélectionnée parmi une chaîne hydrocarbonée, une liaison éther et une liaison ester ; et X² représente un groupe de liaison de valence y contenant au moins l'une quelconque sélectionnée parmi une chaîne hydrocarbonée, une liaison éther et une liaison ester.

2. Composition d'encre pour jet d'encre selon la revendication 1, dans laquelle le composant A contient un composé de (méth)acrylate polyfonctionnel.

3. Composition d'encre pour jet d'encre selon la revendication 2, dans laquelle la teneur du composé de (méth)acrylate polyfonctionnel est de 60 % en masse ou plus par rapport à la quantité totale de la composition d'encre pour jet d'encre.

4. Composition d'encre pour jet d'encre selon l'une quelconque des revendications précédentes, dans laquelle le composant C est une huile végétale contenant 10 % en masse ou plus d'acides gras saturés sur la base de la quantité totale d'acides gras incluse dans le composant (C).

5. Composition d'encre pour jet d'encre selon l'une quelconque des revendications précédentes, dans laquelle la valeur d'iode du composant C est de 140 ou moins.

6. Composition d'encre pour jet d'encre selon l'une quelconque des revendications précédentes, dans laquelle la teneur du composant C est de 3 % en masse à 15 % en masse par rapport à la quantité totale de la composition d'encre pour jet d'encre.

7. Composition d'encre pour jet d'encre selon l'une quelconque des revendications précédentes, dans laquelle la teneur du composé représenté par la formule (1) ou (2) est de 0,01 % en masse à 10 % en masse par rapport à la quantité totale de la composition d'encre pour jet d'encre.

8. Composition d'encre pour jet d'encre selon l'une quelconque des revendications précédentes, dans laquelle le composant B contient en outre un composé de bisacylphosphine ayant un poids moléculaire de 340 ou plus.

9. Composition d'encre pour jet d'encre selon l'une quelconque des revendications précédentes, qui ne comprend pas d'initiateur de polymérisation ayant un poids moléculaire de moins de 340 en tant que composant B, ou la teneur de l'initiateur de polymérisation ayant un poids moléculaire de moins de 340 est de 1 % en masse ou moins par rapport à la quantité totale de la composition d'encre pour jet d'encre.

10. Utilisation d'une composition d'encre pour jet d'encre selon l'une quelconque des revendications précédentes, pour impression d'emballage.

11. Procédé d'enregistrement à jet d'encre comprenant :
la décharge d'une composition d'encre pour jet d'encre telle que définie selon l'une quelconque des revendications 1 à 9 sur un support ; et
ensuite l'irradiation de la composition d'encre pour jet d'encre avec des rayons d'énergie active dans une atmosphère de pression partielle d'oxygène de 0,1 atm ou moins pour durcir la composition d'encre pour jet d'encre.

12. Procédé d'enregistrement à jet d'encre selon la revendication 11, dans lequel le support est un film de résine ayant une épaisseur de film de 10 µm à 90 µm et contenant au moins un composant sélectionné parmi le poly(téréphtalate d'éthylène), le polyéthylène, le polypropylène et le Nylon.

13. Procédé d'enregistrement à jet d'encre selon la revendication 11 ou la revendication 12, dans lequel les rayons d'énergie active sont des rayons d'énergie active irradiés depuis une DEL.

14. Matériau imprimé obtenu par le procédé d'enregistrement à jet d'encre selon l'une quelconque des revendications 11 à 13.
